# EUROPEAN PATENT SPECIFICATION

(11) **EP 4 566 095 B1**
(45) Date of publication and mention of the grant of the patent: **19.08.2026**
(21) Application number: 23804569.4
(22) Date of filing: 25.09.2023
(51) Int. Cl.: H10D 89/60, H10W 42/60, H10W 72/90

(54) **SEMICONDUCTOR DEVICE HAVING DUMMY PAD AND METHOD FOR FORMING THE SAME**
HALBLEITERBAUELEMENT MIT DUMMY-PAD UND HERSTELLUNGSVERFAHREN DAFÜR
DISPOSITIF À SEMI-CONDUCTEUR À PLOT FACTICE ET SON PROCÉDÉ DE FORMATION

(43) Date of publication of application: 11.06.2025
(73) Proprietor: Yangtze Memory Technologies Co., Ltd., Wuhan Hubei 430000 (CN)
(72) Inventor: YANG, Fanfan, Wuhan, Hubei 430000 (CN); YANG, Zhichao, Wuhan, Hubei 430000 (CN); LI, Yang, Wuhan, Hubei 430000 (CN); YANG, Peng, Wuhan, Hubei 430000 (CN)
(74) Representative: Gramm, Lins & Partner Patent- und Rechtsanwälte PartGmbB
(86) International application number: PCT/CN2023/121019
(87) International publication number: WO 2025/065135

(56) References cited:
- US-A1- 2007 253 276
- US-A1- 2008 174 927
- US-A1- 2022 045 035
- US-A1- 2022 068 844

## Description

### BACKGROUND

The present disclosure relates to three-dimensional (3D) memory devices and fabrication methods thereof.

Electrostatic discharge (ESD) is the sudden release of static electricity. ESD can occur when a charged body touches an electronic device. ESD can damage semiconductor devices if not protected against, for example, during the manufacturing and packaging of semiconductor devices. One way to prevent ESD-caused damage is using an ESD protection circuit (a.k.a. ESD circuits) that diverts the ESD current flow by providing a low-impedance path. US 2008/0174927 A1 discloses an ESD protection scheme for semiconductor devices having dummy pads. US 2022/0045035 A1 discloses a semiconductor device and manufacturing methods of the same. US 2022/0068844 A1 discloses a semiconductor device having three-dimensional structure.

### SUMMARY

One aspect relates to a semiconductor device according claim 1.

In some implementations, the semiconductor device further includes a semiconductor layer between the dummy pad and the interconnect structure. In some implementations, the dielectric structure includes an isolation structure in the semiconductor layer.

In some implementations, a lateral dimension of the isolation structure is greater than a lateral dimension of the dummy pad.

In some implementations, the semiconductor device further includes a first via contact in contact with the interconnect structure and separated from the dummy pad by the isolation structure.

In some implementations, the first via contact includes tungsten.

In some implementations, the semiconductor device further includes a second via contact in contact with the dummy pad and extending in the vertical direction. In some implementations, the dielectric structure includes a dielectric layer between the second via contact and the interconnect structure.

In some implementations, the second via contact is separated from the interconnect structure by the dielectric layer.

In some implementations, the second via contact includes tungsten.

In some implementations, the semiconductor device further includes a bonding interface between the dummy pad and the device layer. In some implementations, the interconnect structure includes bonding contacts at the bonding interface.

In some implementations, the interconnect structure further includes a device contact between and connecting the bonding interface and the device layer.

In some implementations, the semiconductor device further includes a pad, another second via contact in contact with the pad, another first via contact in contact with the another second via contact, and another interconnect structure in contact with the another first via contact and the device layer.

In some implementations, the pad and the dummy pad are coplanar, and the interconnect structure and the another interconnect structures are coplanar.

Another embodiment may relate to a semiconductor device including a device layer including an electrostatic discharge (ESD) circuit and a function circuit, a dummy pad disconnected from the function circuit, and an interconnect structure between the device layer and the dummy pad. The dummy pad is connected to the ESD circuit through at least the interconnect structure.

In some implementations, the semiconductor device further includes a first via contact between the dummy pad and interconnect structure and connected to the interconnect structure.

In some implementations, the semiconductor device further includes a semiconductor layer between the dummy pad and the first via contact, a spacer in the semiconductor layer, and a second via contact in contact with the dummy pad and the second via contact and extending through the spacer.

In some implementations, the first and second via contacts includes tungsten.

In some implementations, the dummy pad is connected to the ESD circuit through at least the interconnect structure and the first and second via contacts.

In some implementations, the semiconductor device further includes a bonding interface between the dummy pad and the device layer. In some implementations, the interconnect structure includes bonding contacts at the bonding interface.

In some implementations, the interconnect structure further includes a device contact between and connecting the bonding interface and the device layer.

Another aspect relates to a method for forming a semiconductor device according to claim 12.

In some implementations, another interconnect structure is formed on the device layer and connected to the function circuit, another first via contact is formed on the another interconnect structure and connected to the another interconnect structure, a second via contact is formed on and in contact with the another first via contact and extending through the isolation structure, and a pad is formed on and in contact with the second via contact.

In some implementations, to form the isolation structure, part of a semiconductor layer is removed to form a trench to expose the first via contact and the another first via contact, and a dielectric layer is deposited to fill the trench.

In some implementations, to form the second via contact, part of the isolation structure is removed to form a hole to expose the another first via contact, but not the first via contact, and a metal layer is deposited to fill the hole.

In some implementations, the metal layer includes tungsten.

### BRIEF DESCRIPTION OF THE DRAWINGS

The accompanying drawings, which are incorporated herein and form a part of the specification, illustrate aspects of the present disclosure and, together with the description, further serve to explain the principles of the present disclosure and to enable a person skilled in the pertinent art to make and use the present disclosure.
FIG. 1 illustrates a plan view of a semiconductor device with via contacts below dummy pads, according to some aspects of the present disclosure.
FIG. 2 illustrates a plan view of a semiconductor device without via contacts below dummy pads, according to some aspects of the present disclosure.
FIG. 3A illustrates a cross-sectional side view of a semiconductor device having a dummy pad, according to some aspects of the present disclosure, not falling within the scope of the claimed invention.
FIG. 3B illustrates a cross-sectional side view of a three-dimensional (3D) memory device having a dummy pad and a pad, according to some aspects of the present disclosure, not falling within the scope of the claimed invention.
FIG. 4 illustrates a cross-sectional side view of another semiconductor device having a dummy pad, according to some aspects of the present disclosure, not falling within the scope of the claimed invention.
FIG. 5 illustrates a cross-sectional side view of still another semiconductor device having a dummy pad, according to some aspects of the present disclosure, not falling within the scope of the claimed invention.
FIGs. 6A and 6B illustrate circuit diagrams of ESD circuits, according to some aspects of the present disclosure, not falling within the scope of the claimed invention.
FIGs. 7A-7E illustrate a fabrication process for forming a semiconductor device having a dummy pad, according to some aspects of the present disclosure, not falling within the scope of the claimed invention.
FIGs. 8A-8E illustrate a fabrication process for forming another semiconductor device having a dummy pad, according to an embodiment of the claimed invention.
FIG. 9 is a flowchart of a method for forming a semiconductor device having a dummy pad, according to some aspects of the present disclosure, not falling within the scope of the claimed invention.

The present disclosure will be described with reference to the accompanying drawings.

### DETAILED DESCRIPTION

Although specific configurations and arrangements are discussed, it should be understood that this is done for illustrative purposes only. As such, other configurations and arrangements can be used without departing from the scope of the present disclosure. Also, the present disclosure can also be employed in a variety of other applications. Functional and structural features as described in the present disclosures can be combined, adjusted, and modified with one another and in ways not specifically depicted in the drawings, such that these combinations, adjustments, and modifications are within the scope of the present disclosure.

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

It should be readily understood that the meaning of "on," "above," and "over" in the present disclosure should be interpreted in the broadest manner such that "on" not only means "directly on" something but also includes the meaning of "on" something with an intermediate feature or a layer therebetween, and that "above" or "over" not only means the meaning of "above" or "over" something but can also include the meaning it is "above" or "over" something with no intermediate feature or layer therebetween (i.e., directly on something).

Further, spatially relative terms, such as "beneath," "below," "lower," "above," "upper," and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "substrate" refers to a material onto which subsequent material layers are added. The substrate itself can be patterned. Materials added on top of the substrate can be patterned or can remain unpatterned. Furthermore, the substrate can include a wide array of semiconductor materials, such as silicon, germanium, gallium arsenide, indium phosphide, etc. Alternatively, the substrate can be made from an electrically non-conductive material, such as a glass, a plastic, or a sapphire wafer.

As used herein, the term "layer" refers to a material portion including a region with a thickness. A layer can extend over the entirety of an underlying or overlying structure or may have an extent less than the extent of an underlying or overlying structure. Further, a layer can be a region of a homogeneous or inhomogeneous continuous structure that has a thickness less than the thickness of the continuous structure. For example, a layer can be located between any pair of horizontal planes between, or at, a top surface and a bottom surface of the continuous structure. A layer can extend horizontally, vertically, and/or along a tapered surface. A substrate can be a layer, can include one or more layers therein, and/or can have one or more layers thereupon, thereabove, and/or therebelow. A layer can include multiple layers. For example, an interconnect layer can include one or more conductors and contact layers (in which interconnect lines and/or vertical contacts are formed) and one or more dielectric layers.

In semiconductor devices, dummy pads, like normal pads (referred to herein as "pads"), can be used for wire bonding during semiconductor device packaging. Unlike normal pads, dummy pads, however, are electrically disconnected from the functional circuits (e.g., having transistors or memory cells) of the semiconductor devices and thus, do not facilitate the operations of the functional circuits.

Although a dummy pad is designed to be electrically disconnected from the corresponding functional circuit underneath, ESD from the dummy pad may still cause damage to the functional circuit, for example, during semiconductor device packaging, when the distance between the functional circuit and the interconnect structure below and in contact with the dummy pad is not far enough and/or the functional circuit is not ESD-protected.

To address one or more of the aforementioned issues, the present disclosure introduces various solutions to prevent ESD-caused damage to semiconductor devices from dummy pads. According to one aspect of the present disclosure, at least one of the via contacts in the interconnect structure below and overlaying the dummy pad is removed, for example, being replaced by a dielectric structure, such that the ESD from the dummy pad cannot be propagated to the function circuit. In some implementations, the lateral dimension of an isolation structure (e.g., buried shallow trench isolation (BSTI)) in the dielectric structure is greater than the lateral dimension of the dummy pad, thereby further reducing the risk of burning out due to defects between the dummy pad and the semiconductor layer under the dummy pad. According to another aspect of the present disclosure, the dummy pad is electrically connected to an ESD circuit through at least the interconnect structure, such that the ESD from the dummy pad can be mitigated by the ESD circuit.

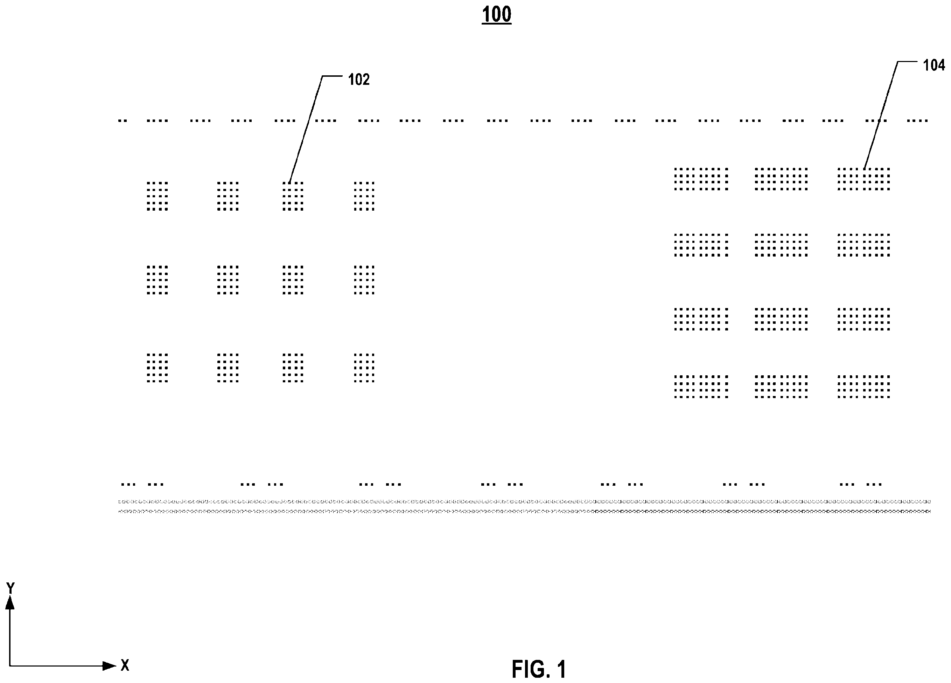

FIG. 1 illustrates a plan view of a semiconductor device 100 with via contacts below dummy pads 104, according to some aspects of the present disclosure. Semiconductor device 100 can include a logic device, such as a microcontroller, a microprocessor, an application processor, etc., a memory device, such as dynamic random-access memory (DRAM), NAND or NOR Flash memory, static random access (SRAM), etc., or an analog device, such as an operational amplifier, a timer, an analog-to-digital converter (ADC), a digital-to-analog converter (DAC), etc.. Semiconductor device 100 can include wire bonding pads used to electrically connect semiconductor device 100 to an external device. For example, the wire bonding pads may be connected to a circuit board or a packaging substrate (e.g., a redistribution layer) or interposer by soldering and gold or aluminum wire attachment. The wire bonding pads thus can function as the bond sites on semiconductor device 100. Semiconductor device 100 can also include function circuits (e.g., as part of its device layer) that are configured to perform the functions of semiconductor device, such as transistors for logic devices, memory cells for memory devices, or resistors, capacitors, and inductors for analog devices.

In some implementations, depending on whether a wire bonding pad is electrically connected to any function circuit, i.e., whether the wire bonding pad also facilitates the operation of a corresponding function circuit (e.g., transmitting/receiving electrical signals to/from the function device), the wire bonding pads include normal pads (a.k.a., pads) 102 and dummy pads 104. For example, each pad 102 may be electrically connected to a corresponding function circuit to facilitate the operation of the function circuit, whereas each dummy pad 104 may not be electrically connected to any function circuit and thus, does not facilitate the operation of any function circuit. As shown in FIG. 1, in some implementations, either pad 102 or dummy pad 104 is in contact with one or more via contacts underneath, which form parts of the interconnect structure overlaying pad 102/dummy pad 104. It is understood that the interconnect structure overlaying pad 102 may connect pad 102 to the corresponding function circuit, whereas the interconnect structure overlaying dummy pad 104 may not connect dummy pad 104 to any function circuit. In some implementations as described below in detail, the interconnect structure overlaying dummy pad 104 may connect dummy pad 104 to an ESD circuit to mitigate the risk of ESD damage from dummy pad 104 to the function circuit that is close to the interconnect structure overlaying dummy pad 104.

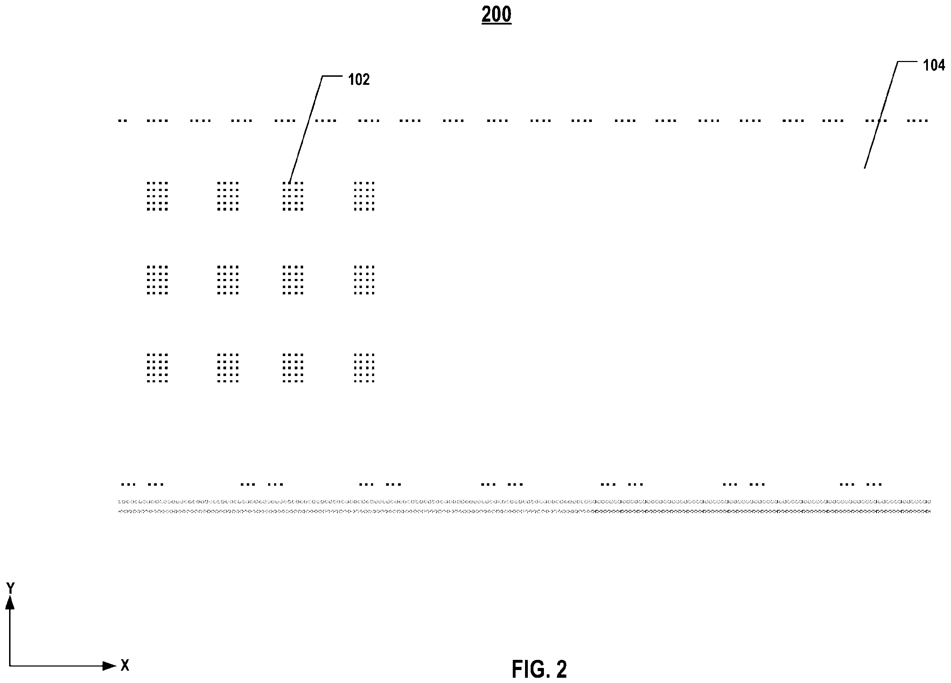

FIG. 2 illustrates a plan view of a semiconductor device 200 without via contacts below dummy pads 104, according to some aspects of the present disclosure. Semiconductor device 200 is similar to semiconductor device 100 except that at least one of the via contacts underneath dummy pad 104 is removed, for example, being replaced by a dielectric structure. As a result, ESD from dummy pad 104 can be isolated by the dielectric structure before reaching to any function circuit through the interconnect structure overlaying dummy pad 104, according to some implementations as described below in detail.

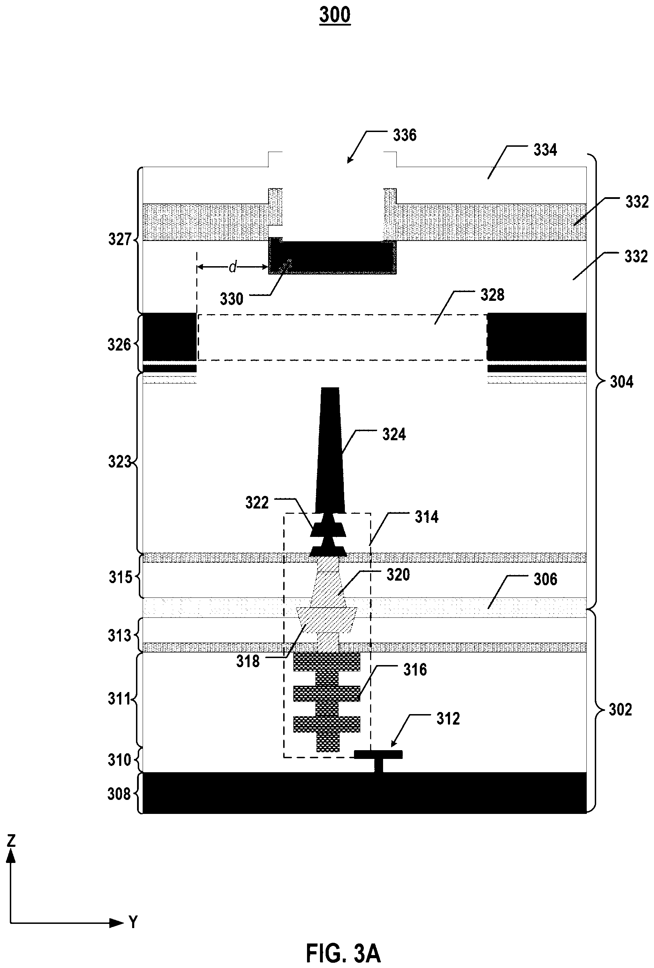

FIG. 3A illustrates a cross-sectional side view of a semiconductor device 300 having a dummy pad 330, according to some aspects of the present disclosure, not falling within the scope of the claimed invention. Semiconductor device 300 may be an example of semiconductor device 200. As shown FIG. 3A, semiconductor device 300 is a bonded chip including a first structure 302 and a second structure 304, which are stacked over one another in different planes in the vertical direction (e.g., the z-direction), according to some implementations. First and second structures 302 and 304 are bonded at a bonding interface 306 therebetween, according to some implementations.

As shown in FIG. 3A, first structure 302 can include a substrate 308, which can include silicon (e.g., single crystalline silicon), silicon germanium (SiGe), gallium arsenide (GaAs), germanium (Ge), silicon on insulator (SOI), or any other suitable materials. In some implementations, substrate 308 includes single crystalline silicon, which is part of the wafer on which first structure 302 is fabricated, either in its native thickness or being thinned. In some implementations, first substrate 302 includes, for example, polysilicon, which is a semiconductor layer replacing the part of wafer on which first structure 302 is fabricated. It is noted that *x, y,* and *z* axes are included in FIGs. 1, 2, and 3A to further illustrate the spatial relationship of the components in semiconductor devices 100, 200, and 300. Substrate 308 of semiconductor device 300 includes two lateral surfaces extending laterally in the *x-y* plane: a top surface on the front side of the wafer on which a device layer 310 can be formed, and a bottom surface on the backside opposite to the front side of the wafer. The z-axis is perpendicular to both the *x* and *y* axes. As used herein, whether one component (e.g., a layer or a device) is "on," "above," "below," or "underneath" another component (e.g., a layer or a device) of semiconductor device 300 is determined relative to substrate 308 of semiconductor device 300 in the z-direction (the vertical direction perpendicular to the *x-y* plane) when substrate 308 is positioned in the lowest plane of semiconductor device 300 in the z-direction. The same notion for describing the spatial relationship is applied throughout the present disclosure.

As shown in FIG. 3A, first structure can include device layer 310 on substrate 308. In some implementations, device layer 310 includes a function circuit 312. In some implementations, semiconductor device 300 is a NAND Flash memory device in which the memory cells are formed in an array of NAND memory strings, and function circuit 312 is a peripheral circuit (a.k.a. control and sensing circuits) that facilitates the operations of the NAND memory strings and includes any suitable digital, analog, and/or mixed-signal circuits. For example, the peripheral circuit can include one or more of a page buffer, a decoder (e.g., a row decoder and a column decoder), a sense amplifier, a driver (e.g., a word line driver), an input/output circuit, a charge pump, a voltage source or generator, a current or voltage reference, any portions (e.g., a sub-circuit) of the functional circuits mentioned above, or any active or passive components of the circuit (e.g., transistors, diodes, resistors, or capacitors). Function circuit 312 can use complementary metal-oxide-semiconductor (CMOS) technology, e.g., which can be implemented with logic processes in any suitable technology nodes.

In some implementations, first structure 302 further includes an interconnect layer 311 above device layer 310 to transfer electrical signals to and from device layer 310. As shown in FIG. 3A, interconnect layer 311 can be vertically between bonding interface 306 and device layer 310 (including function circuit 312). Interconnect layer 311 can include a plurality of interconnects (also referred to herein as "contacts"), including lateral lines and via contacts. As used herein, the term "interconnects" can broadly include any suitable types of interconnects, such as middle-end-of-line (MEOL) interconnects and back-end-of-line (BEOL) interconnects. Interconnect layer 311 can further include one or more interlayer dielectric (ILD) layers (also known as "intermetal dielectric (IMD) layers") in which the lateral lines and via contacts can form. That is, interconnect layer 311 can include lateral lines and via contacts in multiple ILD layers. Although not shown in FIG. 3A, it is understood that function circuit 312 in device layer 310 may be electrically connected to any other suitable function circuits through the interconnects in interconnect layer 311. The interconnects in interconnect layer 311 can include conductive materials including, but not limited to, tungsten (W), cobalt (Co), copper (Cu), aluminum (Al), silicides, or any combination thereof. The ILD layers in interconnect layer 311 can include dielectric materials including, but not limited to, silicon oxide, silicon nitride, silicon oxynitride, low dielectric constant (low-k) dielectrics, or any combination thereof. In some implementations, the interconnects in interconnect layer 311 include device contacts 316, for example, in metal 3-5 (M3-M5) layers. Device contacts 316 can include Cu, which has a relatively low resistivity (better electrical performance) among conductive metal materials.

As shown in FIG. 3A, first structure 302 can further include a bonding layer 313 at bonding interface 306 and above and in contact with interconnect layer 311. Bonding layer 313 can include a plurality of bonding contacts 318 and dielectrics electrically isolating bonding contacts 318. Bonding contacts 318 can include conductive materials including, but not limited to, W, Co, Cu, Al, silicides, or any combination thereof. In some implementations, bonding contacts 318 of bonding layer 313 include Cu. The remaining area of bonding layer 313 can be formed with dielectrics including, but not limited to, silicon oxide, silicon nitride, silicon oxynitride, low-k dielectrics, or any combination thereof. Bonding contacts 318 and surrounding dielectrics in bonding layer 313 can be used for hybrid bonding (also known as "metal/dielectric hybrid bonding"), which is a direct bonding technology (e.g., forming bonding between surfaces without using intermediate layers, such as solder or adhesives) and can obtain metal-metal (e.g., Cu-to-Cu) bonding and dielectric-dielectric (e.g., SiO₂-to-SiO₂) bonding simultaneously.

As shown in FIG. 3A, second structure 304 can include a bonding layer 315 at bonding interface 306, e.g., on the opposite side of bonding interface 306 with respect to bonding layer 313 in first structure 302. Bonding layer 315 can include a plurality of bonding contacts 320 and dielectrics electrically isolating bonding contacts 320. Bonding contacts 320 can include conductive materials, such as Cu. The remaining area of bonding layer 315 can be formed with dielectric materials, such as silicon oxide. Bonding contacts 320 and surrounding dielectrics in bonding layer 315 can be used for hybrid bonding. In some implementations, bonding interface 306 is the place at which bonding layers 313 and 315 are met and bonded. In practice, bonding interface 306 can be a layer with a certain thickness that includes the top surface of bonding layer 313 of first structure 302 and the bottom surface of bonding layer 315 of second structure 304.

As shown in FIG. 3A, second structure 304 can further include an interconnect layer 323 above bonding layer 315 to transfer electrical signals. Interconnect layer 323 can include a plurality of interconnects, such as MEOL interconnects and BEOL interconnects. Although not shown in FIG. 3A, in some examples, the interconnects in interconnect layer 323 also include local interconnects, such as bit line contacts and word line contacts. Interconnect layer 323 can further include one or more ILD layers in which the lateral lines and via contacts can form. The interconnects in interconnect layer 323 can include conductive materials including, but not limited to, W, Co, Cu, Al, silicides, or any combination thereof. The ILD layers in interconnect layer 323 can include dielectric materials including, but not limited to, silicon oxide, silicon nitride, silicon oxynitride, low-k dielectrics, or any combination thereof. In some implementations, the interconnects in interconnect layer 323 include W, which has a relatively high thermal budget (compatible with high-temperature processes) and good quality (fewer defects, e.g., voids) among conductive metal materials.

As shown in FIG. 3A, second structure 304 can further include a semiconductor layer 326 above interconnect layer 323. Semiconductor layer 326 can include semiconductor materials. In some implementations, semiconductor layer 326 is a thinned silicon substrate having single crystalline silicon. In some implementations, semiconductor layer 326 is a deposited polysilicon layer that replaces at least part of a silicon substrate having single crystalline silicon. It is understood that in some examples, trench isolations and doped regions (not shown) may be formed in semiconductor layer 326 as well. It is also understood that in some examples, semiconductor layer 326 may include multiple semiconductor layers in the vertical direction with dielectric layers formed therebetween.

As shown in FIG. 3A, second structure 304 can further include a pad-out layer 327 above semiconductor layer 326. Pad-out layer 327 can include dummy pad 330, one or more ILD layers 332 (e.g., a silicon oxide layer and a silicon nitride layer), and a protective layer 334 (e.g., a polyimide layer) at the top surface of semiconductor device 300. Pad-out layer 327 and interconnect layer 323 can be formed on opposite sides of semiconductor layer 326. In some implementations, an opening 336 is formed through protective layer 334 and ILD layers 332 in pad-out layer 327 to expose dummy pad 330, allowing wire bonding to be performed on the top surface of dummy pad 330.

Consistent with the scope of the present disclosure, semiconductor device 300 can include a dielectric structure between device layer 310 and dummy pad 330 in the vertical direction (e.g., the z-direction in FIG. 3A). The dielectric structure can extend in a lateral direction (e.g., in the*y-*direction in FIG. 3A) and in the vertical direction (e.g., the z-direction in FIG. 3A). In some implementations as shown in FIG. 3A, the dielectric structure includes an isolation structure 328, such as a BSTI, in semiconductor layer 326. For example, isolation structure 328 may include silicon oxide. Semiconductor device 300 can also include an interconnect structure 314 between device layer 310 and the dielectric structure (e.g., isolation structure 328 in FIG. 3A) in the vertical direction (e.g., the z-direction in FIG. 3A). Interconnect structure 314 can extend in the vertical direction (e.g., the z-direction in FIG. 3A). Semiconductor layer 326 can be disposed between dummy pad 330 and interconnect structure 314 in the vertical direction. As shown in FIG. 3A, isolation structure 328, interconnect structure 314, and dummy pad 330 are overlaid, according to some implementations, which are considered corresponding structures in the present disclosure. In other words, for each dummy pad 330, semiconductor device 300 can include corresponding overlaying isolation structure 328 and interconnect structure 314.

As shown in FIG. 3A, interconnect structure 314 can include bonding contacts 320 and 318 in bonding layers 315 and 313, as well as device contacts 316 in interconnect layer 311 of first structure 302. Device contacts 316 are disposed between bonding interface 306 and device layer 310, and bonding interface 306 is disposed between dummy pad 330 and device layer 310 in the vertical direction, according to some implementations. It is understood that in some implementations, interconnect structure 314 may further include interconnects 322 in interconnect layer 323 of second structure 304.

As shown in FIG. 3A, second structure 304 of semiconductor device 300 can further include a via contact 324 extending in the vertical direction in interconnect layer 323. Via contact 324 can include W. In some implementations, via contact 324 is in contact with interconnect structure 314, but is separated from dummy pad 330 by isolation structure 328. Thus, even if device contacts 316 of interconnect structure 314 is not far enough from function circuit 312 in device layer 310 to prevent ESD damage to function circuit 312 through interconnect structure 314 and via contact 324, isolation structure 328 between dummy pad 330 and via contact 324 can still prevent ESD from propagating from dummy pad 330 to via contact 324. In some implementations, the thickness (e.g., in the vertical direction) of isolation structure 328 is between 500 nm and 1000 nm (e.g., 500 nm, 600 nm, 700 nm, 800 nm, 900 nm, 1000 nm, any range bounded by the lower end by any of these values, or in any range defined by any two of these values).

In some implementations, the lateral dimension of isolation structure 328 (e.g., in the *y-*direction of FIG. 3A) is greater than the lateral dimension (e.g., in the *y*-direction of FIG. 3A) of dummy pad 330. As a result, even if defects may be formed in semiconductor layer 326, the risk of burning out between dummy pad 330 and semiconductor layer 326 can be reduced due to the enlarged size of isolation structure 328 (e.g., BSTI). In some implementations, the distance d between the edges of dummy pad 330 and isolation structure 328 in the lateral direction (e.g., the *y*-direction in FIG. 3A) is greater than 1 µm, such as between 1 µm and 5 µm (e.g., 1 µm, 1.5 µm, 2 µm, 2.5 µm, 3 µm, 3.5 µm, 4 µm, 4.5 µm, 5 µm, any range bounded by the lower end by any of these values, or in any range defined by any two of these values).

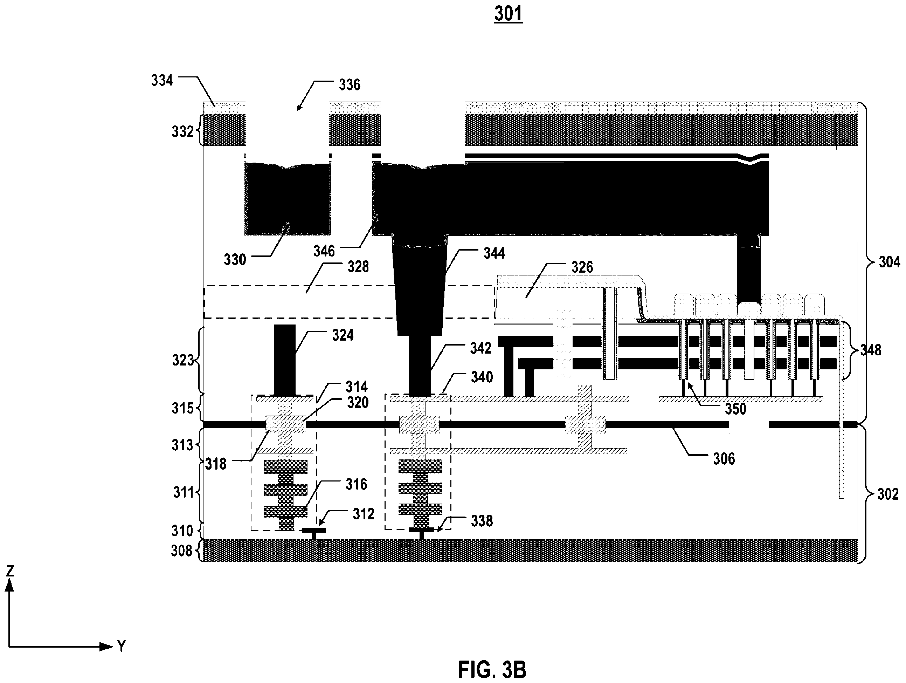

FIG. 3B illustrates a cross-sectional side view of a 3D memory device 301 having dummy pad 330 and a pad 346, according to some aspects of the present disclosure, not falling within the scope of the claimed invention. 3D memory device 301 may be an example of semiconductor device 300 in FIG. 3A, such as a NAND Flash memory device. The same components that have been described above with respect to FIG. 3A will not be repeated for ease of description.

As shown in FIG. 3B, 3D memory device 301 can further include a pad 346, a via contact 344 below and in contact with pad 346, a via contact 342 below and in contact with via contact 344, and interconnect structure 340 below and in contact with via contact 342. Pad 346, via contacts 344 and 342, and interconnect structure 340 are overlaid, according to some implementations. As described below in detail with respect to the fabrication process, pad 346 and dummy pad 330 can be formed by the same processes and are coplanar. Similarly, interconnect structure 314 and interconnect structure 340 can be formed by the same processes and are coplanar, and via contact 324 and via contact 342 can be formed by the same processes and are coplanar. Via contact 344 extends through isolation structure 328 (e.g., BSTI) and connects pad 346 and via contact 342, according to some implementations. Thus, different from dummy pad 330 and interconnect structure 314, which are electrically isolated by isolation structure 328, pad 346 can be electrically connected to interconnect structure 340 through via contacts 344 and 342. Like via contact 324, via contacts 344 and 342 may include W.

As shown in FIG. 3B, device layer 310 can further include function circuit 338 electrically connected to interconnect structure 340, which is different from function circuit 312 that is electrically isolated from interconnect structure 314. As a result, pad 346 can be electrically connected to function circuit 338 in device layer 310 through via contacts 344 and 342 and interconnect structure 340, thereby facilitating the operations of function circuit 338. Although not shown, it is understood that device layer 310 may further include an ESD circuit electrically connected to function circuit 338 and interconnect structure 340 to avoid the ESD damage from pad 346.

In some implementations, 3D memory device 301 further includes a memory cell array, such as an array of NAND memory strings 350 above bonding interface 306 in second structure 304. In some implementations, NAND memory strings 350 are disposed between semiconductor layer 326 and bonding interface 306 in the vertical direction. In some implementations, semiconductor layer 326 is disposed above memory stack 348 and in contact with the sources of NAND memory strings 350. In some implementations, each NAND memory string 350 is a "charge trap" type of NAND memory string including any suitable channel structures. It is understood that NAND memory strings 350 are not limited to the "charge trap" type of NAND memory strings and may be "floating gate" type of NAND memory strings in other examples.

Each NAND memory string 350 extends vertically through a plurality of pairs each including a conductive layer and a dielectric layer, according to some implementations. The stacked and interleaved conductive layers and dielectric layers are also referred to herein as a stack structure, e.g., a memory stack 348. Memory stack 348 and via contact 324 and 342 can be coplanar. Thus, via contacts 324 and 342 may be referred to as "array contact" as well since they are coplanar with the memory cell array in memory stack 348. The interleaved conductive layers and dielectric layers in memory stack 348 alternate in the vertical direction, according to some implementations. Each conductive layer can include a gate electrode (gate line) surrounded by an adhesive layer and a gate dielectric layer. The adhesive layer can include conductive materials, such as titanium nitride (TiN), which can improve the adhesiveness between the gate electrode and the gate dielectric layer. The gate electrode of the conductive layer can extend laterally as a word line, ending at one or more staircase structures of memory stack 348.

Compared with pad 346, which is electrically connected to corresponding interconnect structure 340 through two via contacts 344 and 342, dummy pad 330 is separated from via contact 324 by isolation structure 328, according to some implementations. In other words, one of the two via contacts overlaying dummy pad 330 (i.e., the one coplanar with via contact 344) is replaced by isolation structure 328 to ensure that electrical insulation between dummy pad 330 and interconnect structure 314 to avoid ESD damage to function circuit 312 even if the distance between interconnect structure 314 and function circuit 312 is too close without the protection of an ESD circuit for function circuit 312, according to some implementations.

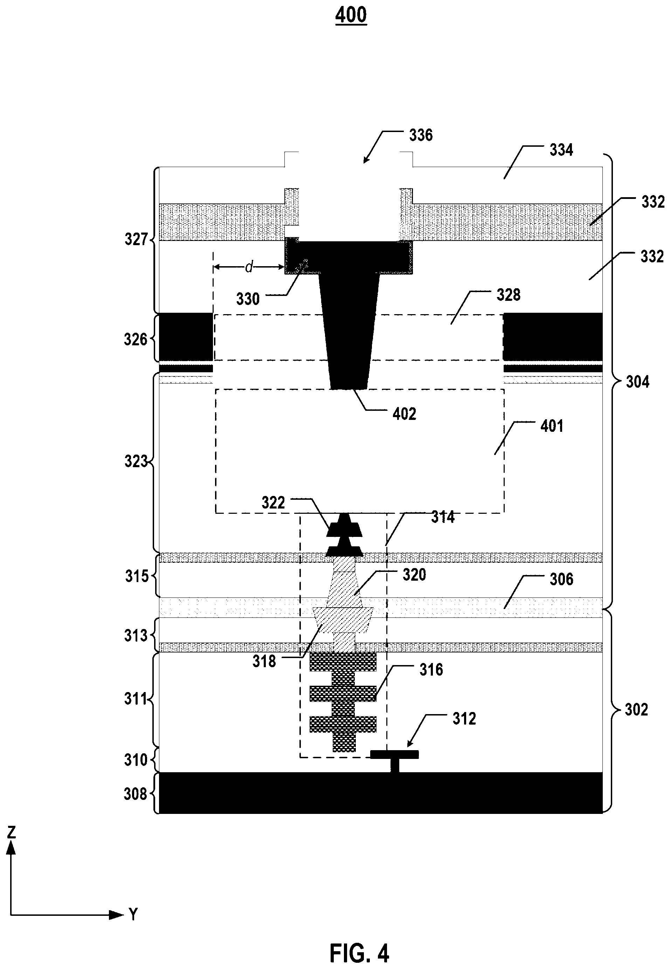

To separate dummy pad 330 from interconnect structure 314, either or both of the two via contacts overlaying dummy pad 330 can be replaced by a dielectric structure. Instead of removing the via contact that is in contact with dummy pad 330 as shown in FIGs. 3A and 3B, in another example, the other via contact (e.g., 324) that is in contact with interconnect structure 314 can be removed to achieve the same result. FIG. 4 illustrates a cross-sectional side view of another semiconductor device 400 having dummy pad 330, according to some aspects of the present disclosure. Semiconductor device 400 may be another example of semiconductor device 200. The same components that have been described above with respect to FIG. 3A will not be repeated for ease of description.

Consistent with the scope of the present disclosure, semiconductor device 400 can include a dielectric structure between device layer 310 and dummy pad 330 in the vertical direction (e.g., the z-direction in FIG. 4). The dielectric structure can extend in a lateral direction (e.g., in the *y-*direction in FIG. 4) and in the vertical direction (e.g., the z-direction in FIG. 4). In some implementations as shown in FIG. 4, the dielectric structure includes a dielectric layer 401 in interconnect layer 323. For example, dielectric layer 401 may include silicon oxide. Semiconductor device 400 can also include interconnect structure 314 between device layer 310 and the dielectric structure (e.g., dielectric layer 401 in FIG. 4) in the vertical direction (e.g., the *z-*direction in FIG. 4). Interconnect structure 314 can extend in the vertical direction (e.g., the *z-*direction in FIG. 4). As shown in FIG. 4, dielectric layer 401, interconnect structure 314, and dummy pad 330 are overlaid, according to some implementations, which are considered corresponding structures in the present disclosure. In other words, for each dummy pad 330, semiconductor device 400 can include corresponding overlaying dielectric layer 401 and interconnect structure 314.

Different from semiconductor device 300 in FIG. 3A, semiconductor device 400 can further include a via contact 402 below and in contact with dummy pad 330. In some implementations, via contact 402 extends in the vertical direction (e.g., the z-direction in FIG. 4) through isolation structure 328. Via contact 402 can include W. Since via contact 402 extends through semiconductor layer 326 as well, it may be referred to as "through silicon via (TSV)" in some examples. In contrast to semiconductor device 300 in FIG. 3A, which includes via contact 324 above and in contact with interconnect structure 314, semiconductor device 400, however, does not include via contact 324, but instead, includes dielectric layer 401 between via contact 402 and interconnect structure 314, according to some implementations. That is, via contact 402 can separated from interconnect structure 314 by dielectric layer 401. Thus, even if device contacts 316 of interconnect structure 314 is not far enough from function circuit 312 in device layer 310 to prevent ESD damage to function circuit 312 through interconnect structure 314, dielectric layer 401 between interconnect structure 314 and via contact 402 can still prevent ESD from propagating from dummy pad 330 to interconnect structure 314. In some implementations, the thickness (e.g., in the vertical direction) of isolation structure 328 is between 1000 nm and 2000 nm (e.g., 1000 nm, 1100 nm, 1200 nm, 1300 nm, 1400 nm, 1500 nm, 1600 nm, 1700 nm, 1800 nm, 1900 nm, 2000 nm, any range bounded by the lower end by any of these values, or in any range defined by any two of these values).

In some implementations, the lateral dimension of isolation structure 328 (e.g., in the *y-*direction of FIG. 4) is greater than the lateral dimension (e.g., in the *y*-direction of FIG. 4) of dummy pad 330. As a result, even if defects may be formed in semiconductor layer 326, the risk of burning out between dummy pad 330 and semiconductor layer 326 can be reduced due to the enlarged size of isolation structure 328 (e.g., BSTI). In some implementations, the distance d between the edges of dummy pad 330 and isolation structure 328 in the lateral direction (e.g., the *y*-direction in FIG. 4) is greater than 1 µm, such as between 1 µm and 5 µm (e.g., 1 µm, 1.5 µm, 2 µm, 2.5 µm, 3 µm, 3.5 µm, 4 µm, 4.5 µm, 5 µm, any range bounded by the lower end by any of these values, or in any range defined by any two of these values).

It is understood that, although not shown, in some examples, both via contacts 324 and 402 overlaying dummy pad 330 may be removed, e.g., replaced by isolation structure 328 and dielectric layer 401, such that dummy pad 330 may be separated from interconnect structure 314 by isolation structure 328 and dielectric layer 401 to prevent ESD damage to function circuit 312 from dummy pad 330.

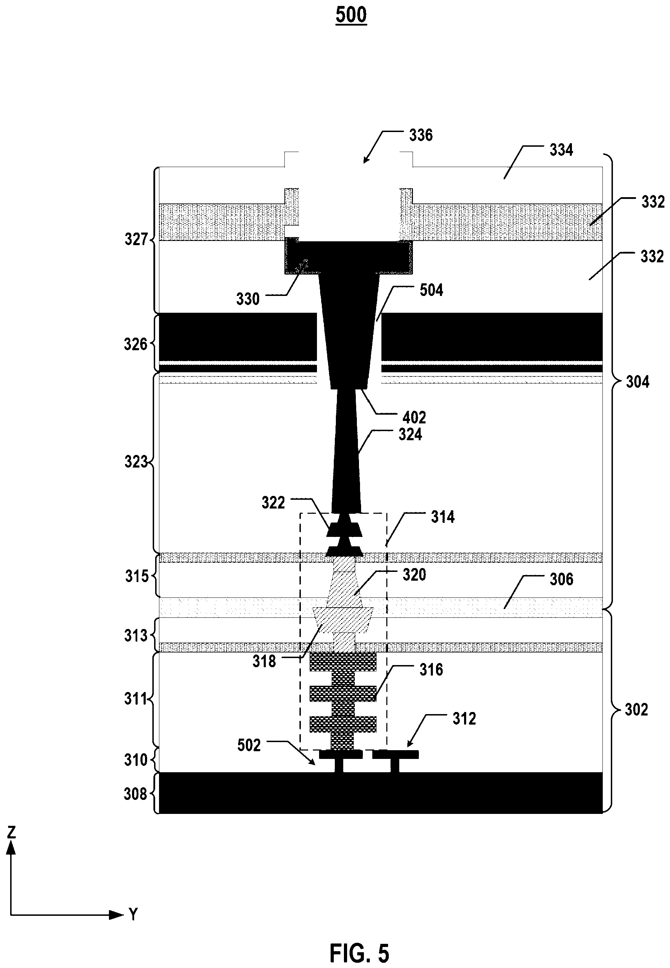

FIG. 5 illustrates a cross-sectional side view of still another semiconductor device 500 having dummy pad 330, according to some aspects of the present disclosure, not falling within the scope of the claimed invention. Semiconductor device 500 may be an example of semiconductor device 100. As shown FIG. 5, semiconductor device 500 is a bonded chip including first structure 302 and second structure 304, which are stacked over one another in different planes in the vertical direction (e.g., the z-direction), according to some implementations. First and second structures 302 and 304 are bonded at bonding interface 306 therebetween, according to some implementations.

As shown in FIG. 5, first structure 302 can include substrate 308, which can include silicon (e.g., single crystalline silicon), SiGe, GaAs, Ge, SOI, or any other suitable materials. In some implementations, substrate 308 includes single crystalline silicon, which is part of the wafer on which first structure 302 is fabricated, either in its native thickness or being thinned. In some implementations, first substrate 302 includes, for example, polysilicon, which is a semiconductor layer replacing the part of wafer on which first structure 302 is fabricated.

As shown in FIG. 5, first structure can include device layer 310 on substrate 308. In some implementations, device layer 310 includes function circuit 312 and an ESD circuit 502. In some implementations, semiconductor device 500 is a NAND Flash memory device in which the memory cells are formed in an array of NAND memory strings, and function circuit 312 is a peripheral circuit (a.k.a. control and sensing circuits) that facilitates the operations of the NAND memory strings and includes any suitable digital, analog, and/or mixed-signal circuits. For example, the peripheral circuit can include one or more of a page buffer, a decoder (e.g., a row decoder and a column decoder), a sense amplifier, a driver (e.g., a word line driver), an input/output circuit, a charge pump, a voltage source or generator, a current or voltage reference, any portions (e.g., a sub-circuit) of the functional circuits mentioned above, or any active or passive components of the circuit (e.g., transistors, diodes, resistors, or capacitors). Function circuit 312 can use CMOS technology, e.g., which can be implemented with logic processes in any suitable technology nodes.

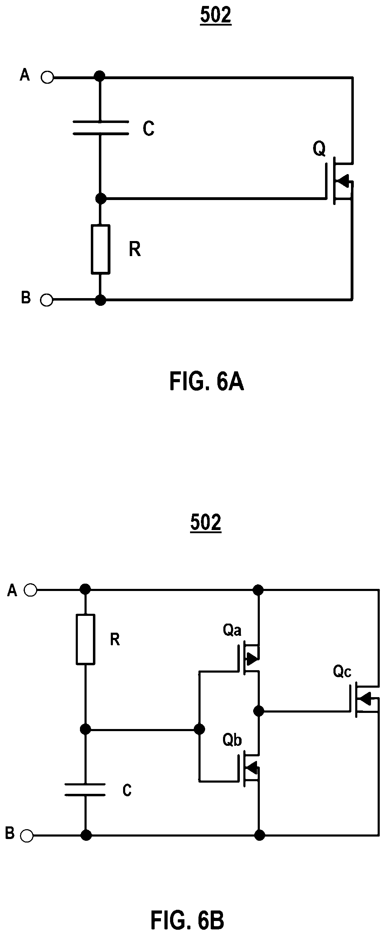

ESD circuit 502 can use ESD suppression components to reduce ESD voltages below a certain limit. These components can be connected in parallel to a vulnerable line. When an ESD strike occurs, the ESD diode can break down and create a low impedance path, which can limit the peak voltage and current by diverting the current flow to ground. In one example, as shown in FIG. 6A, ESD circuit 502 may include a resistor R, a capacitor C, and a transistor Q. The resistor R and the capacitor C may form a resistor-capacitor circuit (RC circuit), and the transistor Q may be a discharge transistor. When an electrostatic signal is input to the electrostatic terminal A, the output terminal of the resistor-capacitor circuit may be at a logic high level, which may cause the transistor Q to turn on, and conduct ESD through the transistor Q. In another example, as shown in FIG. 6B, ESD circuit 502 may include a resistor R, a capacitor C, a transistor Qa, a transistor Qb, and a transistor Qc. The resistor R and the capacitor C may form an RC circuit, the transistor Qa and the transistor Qb may form an inverter, and the transistor Qc may be a discharge transistor. When an electrostatic signal is input to the electrostatic terminal A, the output terminal of the resistor-capacitor circuit may be at a logic low level, the output terminal of the inverter may be at a logic high level, the transistor Qc may be turned on, and ESD may be conducted through the transistor Qc.

As shown in FIG. 5, in some implementations, first structure 302 further includes interconnect layer 311 above device layer 310 to transfer electrical signals to and from device layer 310. Interconnect layer 311 can be vertically between bonding interface 306 and device layer 310 (including function circuit 312 and ESD circuit 502). Interconnect layer 311 can include a plurality of interconnects and one or more ILD layers. That is, interconnect layer 311 can include lateral lines and via contacts in multiple ILD layers. Although not shown in FIG. 5, it is understood that function circuit 312 in device layer 310 may be electrically connected to any other suitable function circuits through the interconnects in interconnect layer 311. The interconnects in interconnect layer 311 can include conductive materials including, but not limited to, W, Co, Cu, Al, silicides, or any combination thereof. The ILD layers in interconnect layer 311 can include dielectric materials including, but not limited to, silicon oxide, silicon nitride, silicon oxynitride, low-k dielectrics, or any combination thereof. In some implementations, the interconnects in interconnect layer 311 include device contacts 316, for example, in metal 3-5 (M3-M5) layers. Device contacts 316 can include Cu, which has a relatively low resistivity (better electrical performance) among conductive metal materials.

As shown in FIG. 5, first structure 302 can further include bonding layer 313 at bonding interface 306 and above and in contact with interconnect layer 311. Bonding layer 313 can include a plurality of bonding contacts 318 and dielectrics electrically isolating bonding contacts 318. Bonding contacts 318 can include conductive materials including, but not limited to, W, Co, Cu, Al, silicides, or any combination thereof. In some implementations, bonding contacts 318 of bonding layer 313 include Cu. The remaining area of bonding layer 313 can be formed with dielectrics including, but not limited to, silicon oxide, silicon nitride, silicon oxynitride, low-k dielectrics, or any combination thereof. Bonding contacts 318 and surrounding dielectrics in bonding layer 313 can be used for hybrid bonding (also known as "metal/dielectric hybrid bonding"), which is a direct bonding technology (e.g., forming bonding between surfaces without using intermediate layers, such as solder or adhesives) and can obtain metal-metal (e.g., Cu-to-Cu) bonding and dielectric-dielectric (e.g., SiO₂-to-SiO₂) bonding simultaneously.

As shown in FIG. 5, second structure 304 can include a bonding layer 315 at bonding interface 306, e.g., on the opposite side of bonding interface 306 with respect to bonding layer 313 in first structure 302. Bonding layer 315 can include a plurality of bonding contacts 320 and dielectrics electrically isolating bonding contacts 320. Bonding contacts 320 can include conductive materials, such as Cu. The remaining area of bonding layer 315 can be formed with dielectric materials, such as silicon oxide. Bonding contacts 320 and surrounding dielectrics in bonding layer 315 can be used for hybrid bonding. In some implementations, bonding interface 306 is the place at which bonding layers 313 and 315 are met and bonded. In practice, bonding interface 306 can be a layer with a certain thickness that includes the top surface of bonding layer 313 of first structure 302 and the bottom surface of bonding layer 315 of second structure 304.

As shown in FIG. 5, second structure 304 can further include interconnect layer 323 above bonding layer 315 to transfer electrical signals. Interconnect layer 323 can include a plurality of interconnects, such as MEOL interconnects and BEOL interconnects. Although not shown in FIG. 5, in some examples, the interconnects in interconnect layer 323 also include local interconnects, such as bit line contacts and word line contacts. Interconnect layer 323 can further include one or more ILD layers in which the lateral lines and via contacts can form. The interconnects in interconnect layer 323 can include conductive materials including, but not limited to, W, Co, Cu, Al, silicides, or any combination thereof. The ILD layers in interconnect layer 323 can include dielectric materials including, but not limited to, silicon oxide, silicon nitride, silicon oxynitride, low-k dielectrics, or any combination thereof. In some implementations, the interconnects in interconnect layer 323 include W, which has a relatively high thermal budget (compatible with high-temperature processes) and good quality (fewer defects, e.g., voids) among conductive metal materials.

As shown in FIG. 5, second structure 304 can further include semiconductor layer 326 above interconnect layer 323. Semiconductor layer 326 can include semiconductor materials. In some implementations, semiconductor layer 326 is a thinned silicon substrate having single crystalline silicon. In some implementations, semiconductor layer 326 is a deposited polysilicon layer that replaces at least part of a silicon substrate having single crystalline silicon. It is understood that in some examples, trench isolations and doped regions (not shown) may be formed in semiconductor layer 326 as well. It is also understood that in some examples, semiconductor layer 326 may include multiple semiconductor layers in the vertical direction with dielectric layers formed therebetween.

As shown in FIG. 5, second structure 304 can further include pad-out layer 327 above semiconductor layer 326. Pad-out layer 327 can include dummy pad 330, one or more ILD layers 332 (e.g., a silicon oxide layer and a silicon nitride layer), and protective layer 334 (e.g., a polyimide layer) at the top surface of semiconductor device 500. Pad-out layer 327 and interconnect layer 323 can be formed on opposite sides of semiconductor layer 326. In some implementations, opening 336 is formed through protective layer 334 and ILD layers 332 in pad-out layer 327 to expose dummy pad 330, allowing wire bonding to be performed on the top surface of dummy pad 330.

Consistent with the scope of the present disclosure, semiconductor device 500 can include interconnect structure 314 between device layer 310 and dummy pad 330 in the vertical direction (e.g., the z-direction in FIG. 5), such that dummy pad 330 is connected to ESD circuit 502 in device layer 310 through at least interconnect structure 314. On the other hand, dummy pad 330 is disconnected from function circuit 312 in device layer 310, according to some implementations. Interconnect structure 314 can extend in the vertical direction (e.g., the z-direction in FIG. 5). Semiconductor layer 326 can be disposed between dummy pad 330 and interconnect structure 314 in the vertical direction. As shown in FIG. 5, interconnect structure 314 and dummy pad 330 are overlaid, according to some implementations, which are considered corresponding structures in the present disclosure. In other words, for each dummy pad 330, semiconductor device 500 can include corresponding overlaying interconnect structure 314.

As shown in FIG. 5, interconnect structure 314 can include bonding contacts 320 and 318 in bonding layers 315 and 313, as well as device contacts 316 in interconnect layer 311 of first structure 302. Device contacts 316 are disposed between bonding interface 306 and device layer 310, and bonding interface 306 is disposed between dummy pad 330 and device layer 310 in the vertical direction, according to some implementations. It is understood that in some implementations, interconnect structure 314 may further include interconnects 322 in interconnect layer 323 of second structure 304.

As shown in FIG. 5, second structure 304 of semiconductor device 500 can further include a via contact 324 extending in the vertical direction in interconnect layer 323. Via contact 324 can include W. In some implementations, via contact 324 is in contact with interconnect structure 314. That is, via contact 324 may be disposed between dummy pad 330 and interconnect structure 314 and connected to interconnect structure 314. Second structure 304 of semiconductor device 500 can further include a spacer 504 in semiconductor layer 326 and a via contact 402 extending in the vertical direction through spacer 504. Spacer 504 can include a dielectric material, such as silicon oxide or silicon nitride. In some implementations, via contact 402 is in contact with dummy pad 330 and via contact 324 at opposite ends. That is, via contact 402 can electrically connect dummy pad 330 and via contact 324. Via contact 402 can include W as well. As a result, dummy pad 330 can be electrically connected to ESD circuit 502 in device layer 310 through at least interconnect structure 314 and via contacts 324 and 402. Thus, ESD from dummy pad 330 can be propagated to ESD circuit 502 and mitigated by ESD circuit 502 to prevent its damage to function circuit 312.

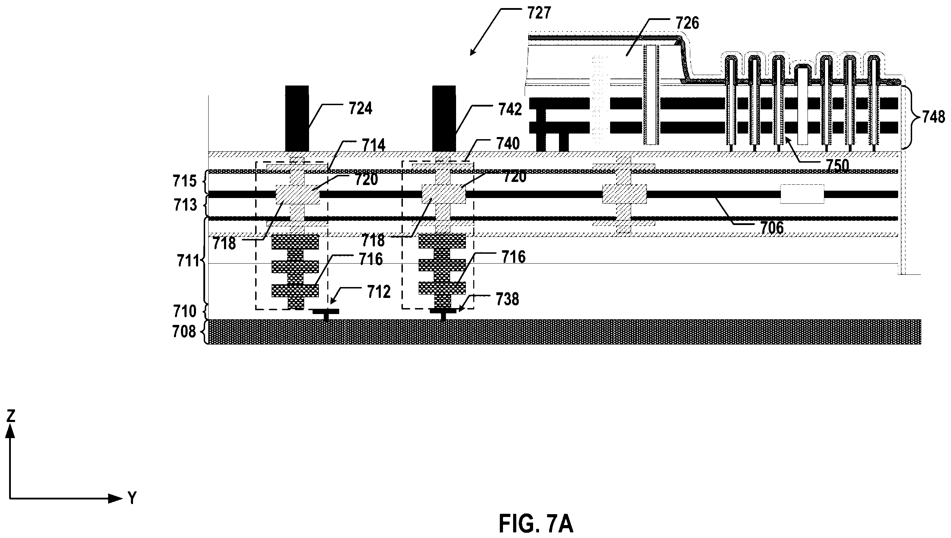

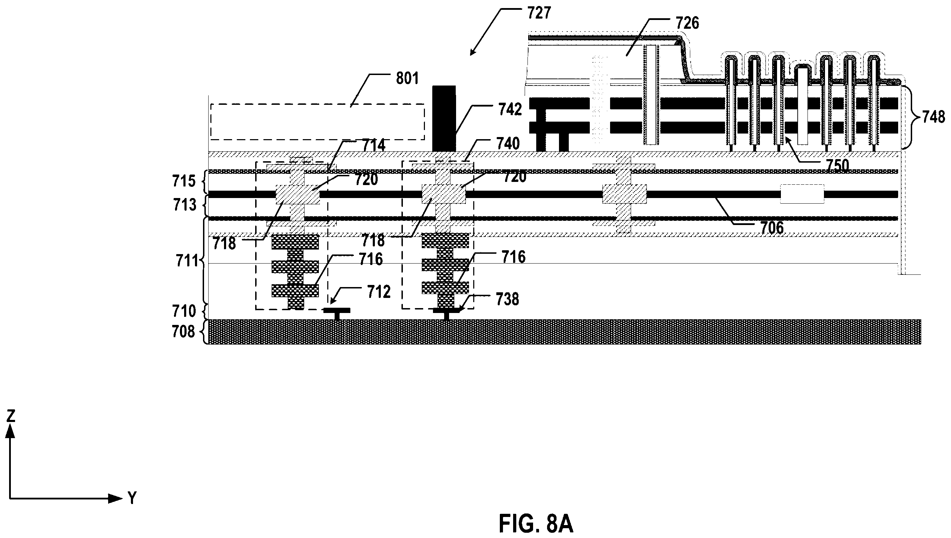

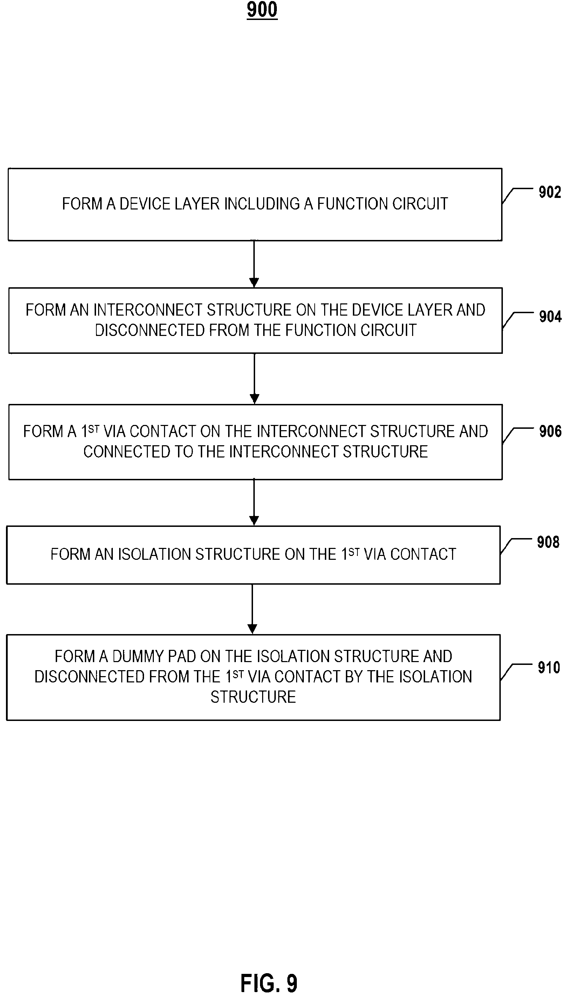

FIGs. 7A-7E illustrate a fabrication process for forming a semiconductor device having a dummy pad, according to some aspects of the present disclosure, not falling within the scope of the claimed invention. FIGs. 8A-8E illustrate a fabrication process for forming another semiconductor device having a dummy pad, according to the claimed invention. FIG. 9 illustrates a flowchart of a method 900 for forming a semiconductor device having a dummy pad, according to some implementations of the present disclosure, not falling within the scope of the claimed invention. Examples of the semiconductor devices depicted in FIGs. 7A-7E, 8A-8E, and 9 include semiconductor devices 300, 301, and 400 depicted in FIGs. 3A, 3B, and 4. FIGs. 7A-7E, 8A-8E, and 9will be described together. It is understood that the operations shown in method 900 are not exhaustive and that other operations can be performed as well before, after, or between any of the illustrated operations. Further, some of the operations may be performed simultaneously, or in a different order than shown in FIG. 9.

Referring to FIG. 9, method 900 starts at operation 902, in which a device layer including a function circuit is formed. As illustrated in FIGs. 7A and 8A, a device layer 710 including function circuits 712 and 738 is formed on a silicon substrate 708 having single crystalline silicon. Function circuits 712 and 738 can be formed by a plurality of processes including, but not limited to, photolithography, dry/wet etch, thin film deposition, thermal growth, implantation, chemical mechanical polishing (CMP), and any other suitable processes. In some implementations, doped regions are formed in silicon substrate 708 by ion implantation and/or thermal diffusion, which function, for example, as wells and source/drain regions of transistors in function circuits 712 and 738. In some implementations, isolation regions (e.g., STIs) are also formed in silicon substrate 708 by wet/dry etch and thin film deposition.

Method 900 proceeds to operation 904, as illustrated in FIG. 9, in which an interconnect structure is formed on the device layer and disconnected from the function circuit. In some implementations, another interconnect structure is formed on the device layer and connected to the function circuit. The interconnect structure and the another interconnect structure can be formed by the same process.

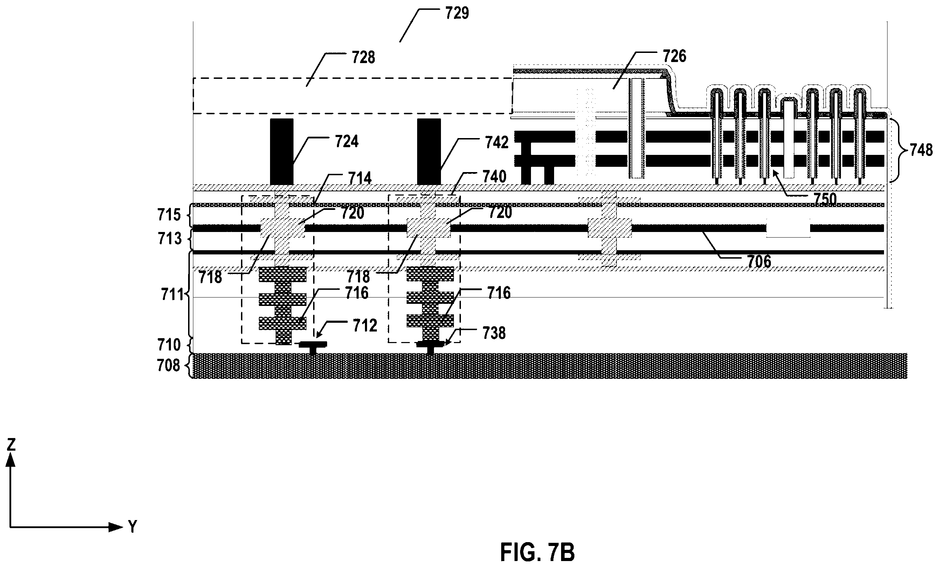

As illustrated in FIGs. 7A and 8A, an interconnect layer 711 is formed above device layer 710. Interconnect layer 711 can include interconnects of MEOL and/or BEOL in a plurality of ILD layers, such as device contacts 716, to make electrical connections with function circuit 738, but not function circuit 712. That is, device contacts 716 can be connected to function circuit 738, but disconnected from function circuit 712. In some implementations, interconnect layer 711 includes multiple ILD layers and interconnects therein formed in multiple processes. For example, the interconnects in interconnect layer 711 can include conductive materials deposited by one or more thin film deposition processes including, but not limited to, chemical vapor deposition (CVD), physical vapor deposition (PVD), atomic layer deposition (ALD), electroplating, electroless plating, or any combination thereof. Fabrication processes to form interconnects can also include photolithography, CMP, wet/dry etch, or any other suitable processes. The ILD layers can include dielectric materials deposited by one or more thin film deposition processes including, but not limited to, CVD, PVD, ALD, or any combination thereof. The ILD layers and interconnects illustrated in FIGs. 7A and 7B can be collectively referred to as interconnect layer 711. In some implementations, the interconnects, such as device contacts 716, in interconnect layer 711 include Cu, which has a relatively low resistivity among conductive metal materials.

As illustrated in FIGs. 7A and 8A, a bonding layer 713 is formed above interconnect layer 711. Bonding layer 713 can include a plurality of bonding contacts 718 surrounded by dielectrics. In some implementations, a dielectric layer is deposited on the top surface of interconnect layer 711 by one or more thin film deposition processes including, but not limited to, CVD, PVD, ALD, or any combination thereof. Bonding contacts 718 can then be formed through the dielectric layer and in contact with the interconnects in interconnect layer 711 by first patterning contact holes through the dielectric layer using patterning process (e.g., photolithography and dry/wet etch of dielectric materials in the dielectric layer). The contact holes can be filled with a conductor (e.g., Cu). In some implementations, filling the contact holes includes depositing an adhesion (glue) layer, a barrier layer, and/or a seed layer before depositing the conductor. For example, the adhesion layer may improve the adhesiveness of the conductor to avoid defects, the barrier layer may prevent metal ion (e.g., Cu ions) diffusing from the conductor into other structures to cause contamination, and the seed layer may facilitate the deposition of the conductor (e.g., Cu) in the contact holes to improve the deposition quality and speed.

As illustrated in FIGs. 7A and 8A, a stack structure, such as a memory stack 748 including interleaved conductive layers and dielectric layers, is formed on a silicon substrate 726. To form memory stack 748, in some implementations, a dielectric stack (not shown) including interleaved sacrificial layers (not shown) and the dielectric layers is formed on silicon substrate 726. In some implementations, each sacrificial layer includes a layer of silicon nitride, and each dielectric layer includes a layer of silicon oxide. The interleaved sacrificial layers and dielectric layers can be formed by one or more thin film deposition processes including, but not limited to, CVD, PVD, ALD, or any combination thereof. Memory stack 748 can then be formed by a gate replacement process, e.g., replacing the sacrificial layers with the conductive layers using wet/dry etch of the sacrificial layers selective to the dielectric layers and filling the resulting recesses with the conductive layers. In some implementations, each conductive layer includes a metal layer, such as a layer of W. It is understood that memory stack 748 may be formed by alternatingly depositing conductive layers (e.g., doped polysilicon layers) and dielectric layers (e.g., silicon oxide layers) without the gate replacement process in some examples. In some implementations, a pad oxide layer (e.g., thermally grown local oxidation of silicon (LOCOS)) including silicon oxide is formed between memory stack 748 and silicon substrate 726.

As illustrated in FIGs. 7A and 8A, NAND memory strings 750 are formed, each of which extends vertically through memory stack 748. In some implementations, fabrication processes to form NAND memory string 750 include forming a channel hole through memory stack 748 (or the dielectric stack) and into silicon substrate 726 using dry etching/and or wet etching, such as deep reactive-ion etching (DRIE), followed by subsequently filling the channel hole with a plurality of layers, such as a memory film (e.g., a tunneling layer, a storage layer, and a blocking layer) and a semiconductor layer, using thin film deposition processes such as ALD, CVD, PVD, or any combination thereof. It is understood that the details of fabricating NAND memory strings 750 may vary depending on the types of channel structures of NAND memory strings 750 and thus, are not elaborated for ease of description.

As illustrated in FIGs. 7A and 8A, a bonding layer 715 is formed above memory stack 748. Bonding layer 715 can include a plurality of bonding contacts 720 surrounded by dielectrics. In some implementations, a dielectric layer is deposited on the top surface of memory stack 748 by one or more thin film deposition processes including, but not limited to, CVD, PVD, ALD, or any combination thereof. Bonding contacts 720 can then be formed through the dielectric layer by first patterning contact holes through the dielectric layer using patterning process (e.g., photolithography and dry/wet etch of dielectric materials in the dielectric layer). The contact holes can be filled with a conductor (e.g., Cu). In some implementations, filling the contact holes includes depositing an adhesion (glue) layer, a barrier layer, and/or a seed layer before depositing the conductor.

As illustrated in FIGs. 7A and 8A, silicon substrate 726 and components formed thereon (e.g., memory stack 748 and NAND memory strings 750 formed therethrough) are flipped upside down. Bonding layer 715 facing down is bonded with bonding layer 713 facing up, i.e., in a face-to-face manner, thereby forming a bonding interface 706. That is, silicon substrate 708 and components formed thereon can be bonded with silicon substrate 726 and components formed thereon in a face-to-face manner, such that bonding contacts 718 in bonding layer 713 are in contact with bonding contacts 720 in bonding layer 715 at bonding interface 706. In some implementations, a treatment process, e.g., plasma treatment, wet treatment and/or thermal treatment, is applied to bonding surfaces prior to bonding. In some implementations, silicon substrate 726 is thinned after the bonding to form a thinned silicon substrate, also referred to herein as a semiconductor layer 726.

As a result of the bonding, e.g., hybrid bonding, bonding contacts 718 and 720 on opposite sides of bonding interface 706 can be inter-mixed. After the bonding, bonding contacts 718 in bonding layer 713 and bonding contacts 720 in bonding layer 715 are aligned and in contact with one another, such that two interconnect structures 714 and 740 can be formed. Interconnect structure 714 or 740 can include bonding contacts 718 and 720 across bonding interface 706 and device contacts 716. As shown in FIGs. 7A and 8A, interconnect structure 714 is formed on device layer 710 and disconnected from function circuit 712, while interconnect structure 740 is formed on device layer 710 and connected to function circuit 738.

Method 900 proceeds to operation 906, as illustrated in FIG. 9, in which a first via contact is formed on the interconnect structure and connected to the interconnect structure. In some implementations, another first via contact on the another interconnect structure and connected to the another interconnect structure. The first via contact and the another first via contacts can be formed by the same process.

As illustrated in FIG. 7A, prior to the bonding, via contacts 724 and 742 are formed, for example, by the same process of forming the word line contacts through memory stack 748. Via contacts 724 and 742 can then be formed through the dielectric layer by first patterning contact holes through the dielectric layer using patterning process (e.g., photolithography and dry/wet etch of dielectric materials in the dielectric layer). The contact holes can be filled with a conductor (e.g., W). In some implementations, filling the contact holes includes depositing an adhesion (glue) layer, a barrier layer, and/or a seed layer before depositing the conductor. After the bonding, via contact 724 can become connected to interconnect structure 714 and formed on interconnect structure 714, as shown in FIG. 7A. Similarly, via contact 742 can become connected to interconnect structure 740 and formed on interconnect structure 740.

Method 900 proceeds to operation 908, as illustrated in FIG. 9, in which an isolation structure is formed on the first via contact. In some implementations, to form the isolation structure, part of a semiconductor layer is removed to form a trench to expose the first via contact and the another first via contact, and a dielectric layer is deposited to fill the trench.

As illustrated in FIG. 7A, a trench 727 is formed by removing part of semiconductor layer 726 to expose one end of via contacts 724 and 742. Trench 727 can be formed by etching semiconductor layer 726, for example, using dry etching and/or wet etching, to remove part of semiconductor layer 726 that covers via contacts 724 and 742 until exposing via contacts 724 and 742.

As illustrated in FIG. 7B, trench 727 (shown in FIG. 7A) is filled with a dielectric layer. For example, a dielectric layer, such as silicon oxide, may be deposited to fill trench 727 by one or more thin film deposition processes including, but not limited to, CVD, PVD, ALD, or any combination thereof. An isolation structure 728 thus can be formed, as part of the deposited dielectric layer, on via contacts 724 and 742, as shown in FIG. 7B.

In some implementations, a second via contact is formed on and in contact with the another first via contact and extending through the isolation structure. To form the second via contact, in some implementations, part of the isolation structure is removed to form a hole to expose the another first via contact, but not the first via contact, and a metal layer is deposited to fill the hole. The metal layer can include W.

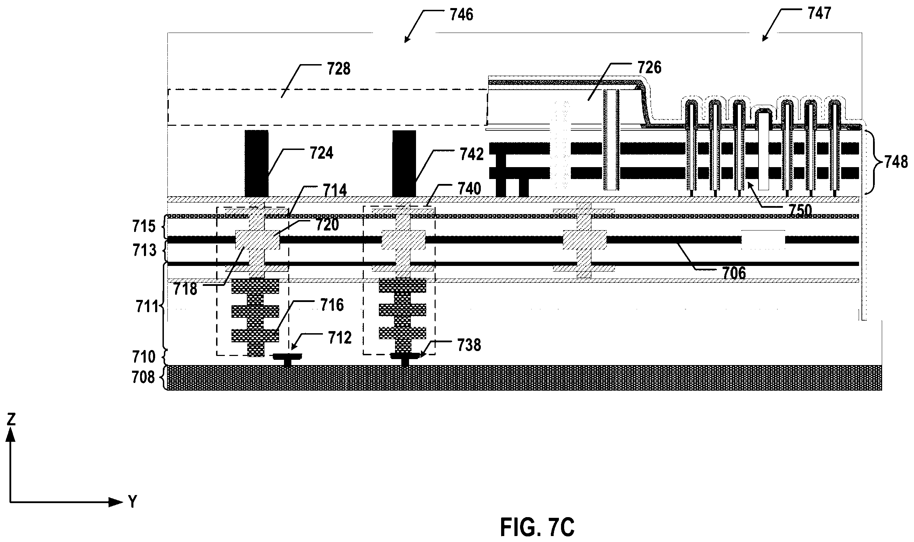

As illustrated in FIG. 7C, a hole 746 is formed by removing part of isolation structure 728 to expose one end of via contact 742, but not via contact 724. Hole 746 can be formed by etching isolation structure 728, for example, using dry etching and/or wet etching, to selectively remove part of isolation structure 728 that covers via contact 742, but not via contact 724 until exposing via contact 742. An etching mask can be first patterned using photolithography process to expose only part of isolation structure 728 that covers via contact 742, but not via contact 724. The etching mask can then protect part of isolation structure 728 that covers via contact 724 during the etching process. It is understood that in some examples, another hole 747 may be formed as well by the same process of forming hole 746, for example, to expose a component in memory stack 748, such as the source end of a slit structure or NAND memory string 750.

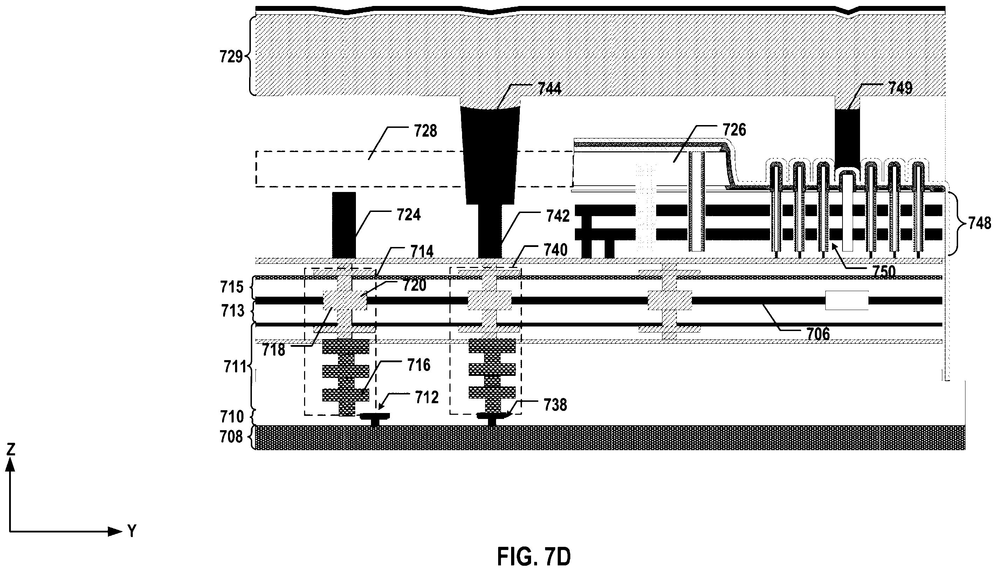

As illustrated in FIG. 7D, hole 746 (shown in FIG. 7C) is filled with a metal layer, such as W. For example, a metal layer, such as W, may be deposited to fill hole 746 by one or more thin film deposition processes including, but not limited to, CVD, PVD, ALD, or any combination thereof. A via contact 744 thus can be formed through isolation structure 728 to be landed on and in contact with via contact 742, as shown in FIG. 7D. In contrast, no via contact can be formed on and in contact with via contact 724, as shown in FIG. 7D. It is understood that in some examples, another via contact 749 may be formed as well by the same process of forming via contact 744, for example, on and in contact with a component in memory stack 748, such as the source end of a slit structure or NAND memory string 750.

Method 900 proceeds to operation 910, as illustrated in FIG. 9, in which a dummy pad is formed on the isolation structure and disconnected from the first via contact by the isolation structure. In some implementations, a pad is formed on and in contact with the second via contact. The dummy pad and the pad can be formed by the same process.

As illustrated in FIG. 7D, a pad layer 729, such as aluminum, is deposited on via contact 744. For example, a metal layer, such as aluminum, may be deposited on via contacts 744 and 749 by one or more thin film deposition processes including, but not limited to, CVD, PVD, ALD, or any combination thereof.

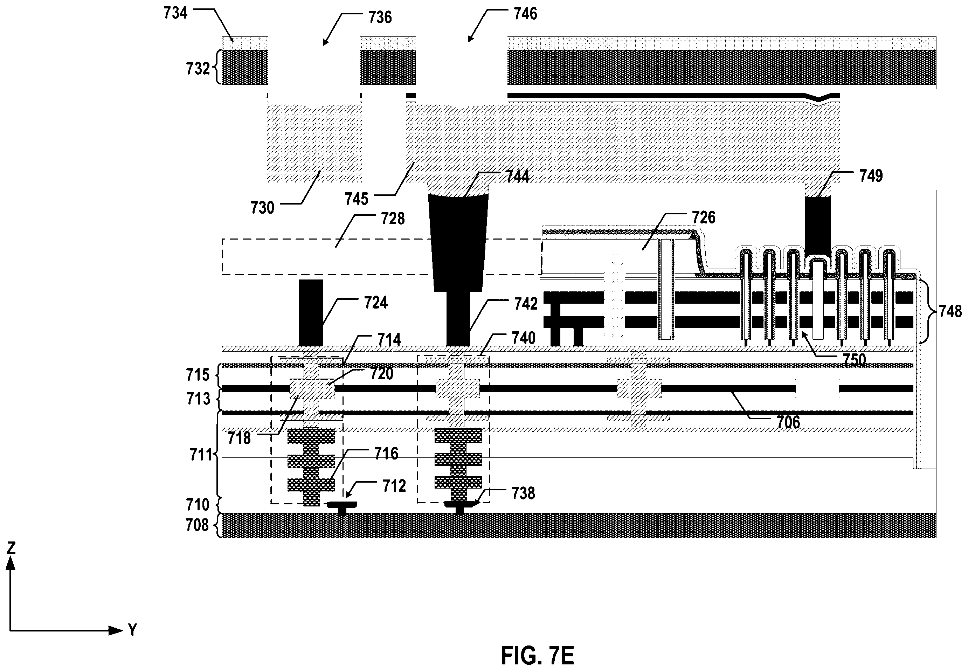

As illustrated in FIG. 7E, pad layer 729 (shown in FIG. 7D) is patterned to form dummy pad 730 and pad 745. Pad 745 can be formed on and in contact with via contact 744 and thus, electrically connected to function circuit 738 in device layer 710 through via contacts 744 and 742 and interconnect structure 740. In contrast, dummy pad 730 can be formed on isolation structure 728 and disconnected from via contact 724 by isolation structure 728. Thus, dummy pad 730 can be electrically disconnected from interconnect structure 714. To form dummy pad 730 and pad 745, a patterning process (e.g., photolithography and dry/wet etch of pad layer 729) can be performed on pad layer 729. A dielectric layer 732 (e.g., including silicon nitride) and a protective layer 734 (e.g., including polyimide) can be subsequently formed on dummy pad 730 and pad 745, followed by a patterning process to form openings 736 and 746 through dielectric layer 732 and protective layer 734 to expose dummy pad 730 and pad 745, respectively.

It is understood that in some examples, different from operation 906 in which a first via contact is formed on the interconnect structure and connected to interconnect structure, a dielectric layer is formed on the interconnect structure.

As illustrated in FIG. 8A, a dielectric layer 801 is formed on interconnect structure 714. That is, via contact 742 is formed only on and connected to interconnect structure 740, but not interconnect structure 714, according to some implementations.

In some implementations, an isolation structure is formed on the another first via contact. In some implementations, to form the isolation structure, part of a semiconductor layer is removed to form a trench to expose the another first via contact, and a dielectric layer is deposited to fill the trench.

As illustrated in FIG. 8A, trench 727 is formed by removing part of semiconductor layer 726 to expose one end of via contact 742. Trench 727 can be formed by etching semiconductor layer 726, for example, using dry etching and/or wet etching, to remove part of semiconductor layer 726 that covers via contact 742 until exposing via contact 742.

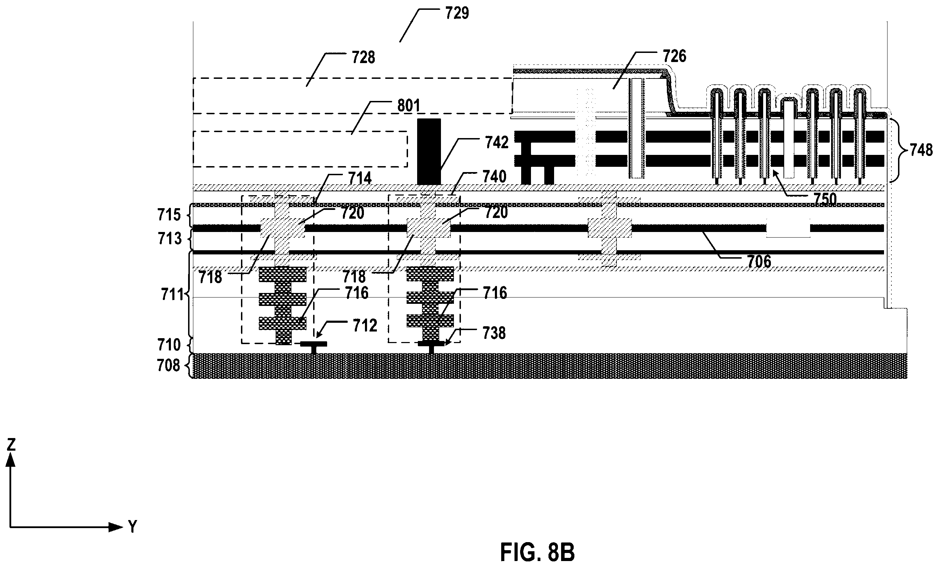

As illustrated in FIG. 8B, trench 727 (shown in FIG. 8A) is filled with a dielectric layer. For example, a dielectric layer, such as silicon oxide, may be deposited to fill trench 727 by one or more thin film deposition processes including, but not limited to, CVD, PVD, ALD, or any combination thereof. An isolation structure 728 thus can be formed, as part of the deposited dielectric layer, on via contact 742, as shown in FIG. 8B.

In some implementations, a second via contact is formed extending through the isolation structure. In some implementations, another second via contact is formed on and connected to the another first via contact and extending through the isolation structure. To form the second via contact and the another second via contact, in some implementations, part of the isolation structure is removed to form holes through the isolation structure, and a metal layer is deposited to fill the holes. The metal layer can include W.

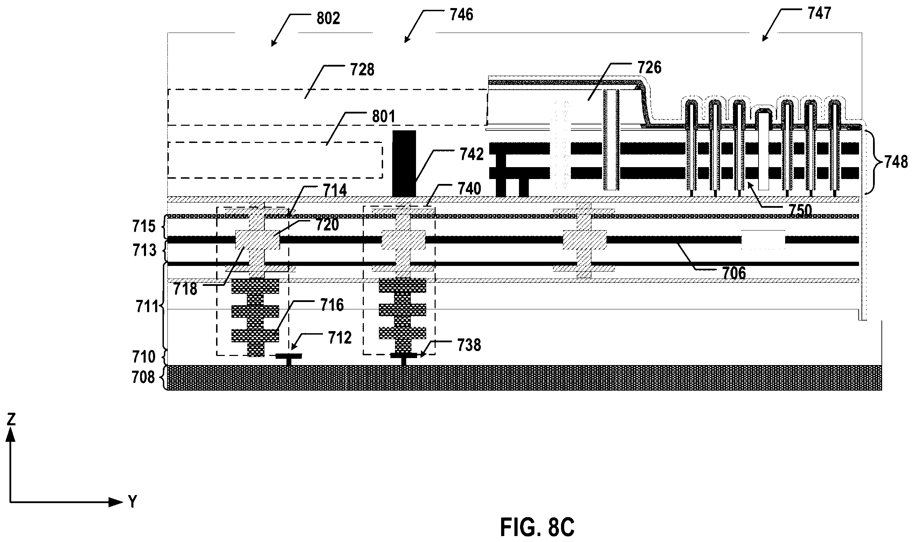

As illustrated in FIG. 8C, holes 746 and 802 are formed by removing part of isolation structure 728. Hole 746 can expose one end of via contact 742, and hole 802 can be aligned with interconnect structure 714. Holes 746 and 802 can be formed by etching isolation structure 728, for example, using dry etching and/or wet etching, to selectively remove part of isolation structure 728 that covers via contact 742 and part of isolation structure 728 that is aligned with interconnect structure 714 until exposing via contact 742. An etching mask can be first patterned using photolithography process to expose part of isolation structure 728 that covers via contact 742 and part of isolation structure 728 that is aligned with interconnect structure 714. It is understood that in some examples, another hole 747 may be formed as well by the same process of forming holes 746 and 802, for example, to expose a component in memory stack 748, such as the source end of a slit structure or NAND memory string 750.

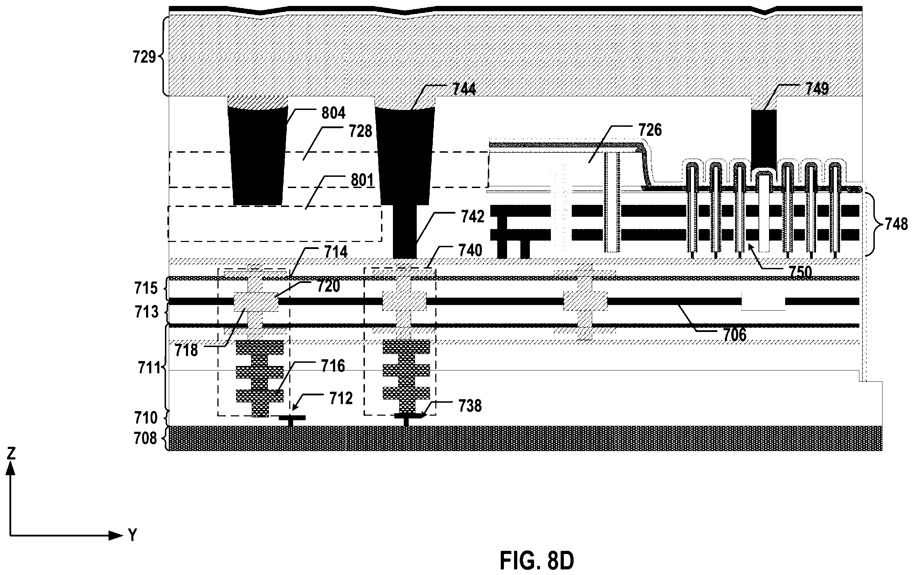

As illustrated in FIG. 8D, holes 746 and 802 (shown in FIG. 8C) are filled with a metal layer, such as W. For example, a metal layer, such as W, may be deposited to fill holes 746 and 802 by one or more thin film deposition processes including, but not limited to, CVD, PVD, ALD, or any combination thereof. A via contact 744 thus can be formed through isolation structure 728 to be landed on and in contact with via contact 742, as shown in FIG. 8D. Another via contact 804 can be formed through isolation structure 728 to be landed on dielectric layer 801 and overlaying interconnect structure 714, as shown in FIG. 8D. It is understood that in some examples, another via contact 749 may be formed as well by the same process of forming via contacts 744 and 804, for example, on and in contact with a component in memory stack 748, such as the source end of a slit structure or NAND memory string 750.

In some implementations, a dummy pad is formed on and in contact with the second via contact. In some implementations, a pad is formed on and in contact with the another second via contact. The dummy pad and the pad can be formed by the same process.

As illustrated in FIG. 8D, pad layer 729, such as aluminum, is deposited on via contacts 744 and 804. For example, a metal layer, such as aluminum, may be deposited on via contacts 744, 804, and 749 by one or more thin film deposition processes including, but not limited to, CVD, PVD, ALD, or any combination thereof.

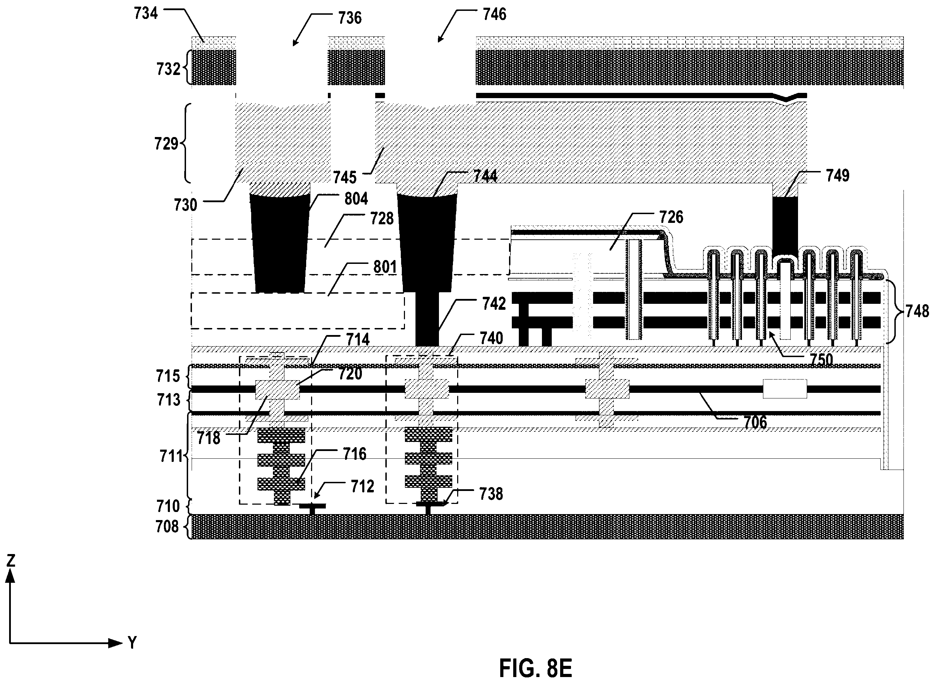

As illustrated in FIG. 8E, pad layer 729 (shown in FIG. 8D) is patterned to form dummy pad 730 and pad 745. Pad 745 can be formed on and in contact with via contact 744 and thus, electrically connected to function circuit 738 in device layer 710 through via contacts 744 and 742 and interconnect structure 740. Dummy pad 730 can be formed on and in contact with via contact 804. Dummy pad 730 and via contact 804, however, can be disconnected from interconnect structure 714 by dielectric layer 801. Thus, dummy pad 730 can be electrically disconnected from interconnect structure 714. To form dummy pad 730 and pad 745, a patterning process (e.g., photolithography and dry/wet etch of pad layer 729) can be performed on pad layer 729. Dielectric layer 732 (e.g., including silicon nitride) and protective layer 734 (e.g., including polyimide) can be subsequently formed on dummy pad 730 and pad 745, followed by a patterning process to form openings 736 and 746 through dielectric layer 732 and protective layer 734 to expose dummy pad 730 and pad 745, respectively.

The breadth and scope of the present disclosure should not be limited by any of the above-described exemplary implementations, but should be defined only in accordance with the following claims.

## Claims

1. A semiconductor device, comprising:
a device layer (310, 710) comprising a function circuit (312, 712);
a dummy pad (330, 730);
a dielectric structure between the device layer and the dummy pad (330, 730) and extending in a vertical direction, wherein the dielectric structure comprises a buried shallow trench isolation (801);
an interconnect structure (314, 714) between the device layer (310, 710) and the dielectric structure and extending in the vertical direction, wherein the dielectric structure, the interconnect structure (310, 710), and the dummy pad (330, 730) are overlaid, wherein the interconnect structure (314, 714) disconnected from the function circuit (312, 712); and
a second via contact (804) vertically extending from the dummy pad (730) through an isolation structure (728) to be landed on the buried shallow trench isolation (801).

2. The semiconductor device of claim 1, further comprising:
a semiconductor layer (326, 726) between the dummy pad (330, 730) and the interconnect (314, 714) structure,
wherein the isolation structure (801) is arranged in the semiconductor layer (326, 726).

3. The semiconductor device of claim 2, wherein a lateral dimension of the isolation structure (801) is greater than a lateral dimension of the dummy pad (330, 730).

4. The semiconductor device of claim 2 or 3, further comprising a first via contact (724) in contact with the interconnect structure and separated from the dummy pad (330, 730) by the isolation structure (801).

5. The semiconductor device of claim 4, wherein the first via contact comprises tungsten.

6. The semiconductor device of claim 1, further comprising:
a second via contact (804) in contact with the dummy pad (330, 730) and extending in the vertical direction,
wherein the dielectric structure comprises a dielectric layer (801) between the second via contact (804) and the interconnect structure (314, 714).

7. The semiconductor device of claim 5, wherein the second via contact (804) is separated from the interconnect structure (314. 714) by the dielectric layer.

8. The semiconductor device of any one of claims 1-7, further comprising a bonding interface (306, 706) between the dummy pad (330, 730) and the device layer (310, 710), wherein the interconnect structure (314, 714) comprises bonding contacts (318, 320, 718, 720) at the bonding interface (306, 706).

9. The semiconductor device of claim 8, wherein the interconnect structure (314, 714) further comprises a device contact (316, 716) between the bonding interface (306, 706) and the device layer (310, 710).

10. The semiconductor device of any one of claims 1-9, further comprising:
a pad (346, 746);
another second via contact (344, 744) in contact with the pad (346, 746);
another first via contact (342. 742) in contact with the another second via contact (344, 744); and
another interconnect structure (340, 740) in contact with the another first via contact (342. 742) and the device layer (310, 710).

11. The semiconductor device of claim 10, wherein
the pad (346, 746) and the dummy pad (330, 730) are coplanar; and
the interconnect structure (314, 714) and the another interconnect structures (340, 740) are coplanar.

12. A method for forming a semiconductor device, comprising:
forming a device layer (310, 710) comprising a function circuit (312, 712);
forming an interconnect structure (314, 714) on the device layer (310, 710) and disconnected from the function circuit (312, 712);
forming a first via contact (724) on the interconnect structure (314, 714) and connected to the interconnect structure (314, 714);
forming a buried shallow trench isolation (801) on the interconnect structure (314, 714);
forming an isolation structure (728);
forming a second via contact (804) through the isolation structure (728) to be landed on the buried shallow trench isolation (801); and
forming a dummy pad (330, 730) on and in contact with the second via contact (804); whereby a dielectric structure between the device layer (310, 710) and the dummy pad (330, 730) comprises the buried shallow trench isolation (801), and the dielectric structure, the interconnect structure (314, 714), and the dummy pad (330, 730) are overlaid.

13. The method of claim 12, , wherein forming the isolation structure (728) comprises forming a trench (727) and depositing a dielectric material to fill the trench.

14. The method of claim 12 or 13, wherein forming the second via contact (804) comprises forming a hole (802) aligned with the interconnect structure (314, 714) and depositing a metal to fill the hole..

15. The method of claim 12 to 14, wherein the second via contact (804) is separated from the interconnect structure (314, 714) by the buried shallow trench isolation (801).

## Patentansprüche

1. Halbleiterbauelement, aufweisend:
eine Bauelementschicht (310, 710), die eine Funktionsschaltung (312, 712) aufweist;
ein Dummy-Pad (330, 730);
eine dielektrische Struktur zwischen der Bauelementschicht und dem Dummy-Pad (330, 730), die sich in vertikaler Richtung erstreckt, wobei die dielektrische Struktur eine vergrabene flache Grabenisolierung (801) aufweist;
eine Verbindungsstruktur (314, 714) zwischen der Bauelementschicht (310, 710) und der dielektrischen Struktur, die sich in vertikaler Richtung erstreckt, wobei die dielektrische Struktur, die Verbindungsstruktur (310, 710) und das Dummy-Pad (330, 730) übereinanderliegen, wobei die Verbindungsstruktur (314, 714) von der Funktionsschaltung (312, 712) getrennt ist; und
einen zweiten Durchkontakt (804), der sich vertikal vom Dummy-Pad (730) durch eine Isolationsstruktur (728) erstreckt, um auf der vergrabenen flachen Grabenisolierung (801) zu landen.

2. Halbleiterbauelement nach Anspruch 1, ferner aufweisend:
eine Halbleiterschicht (326, 726) zwischen dem Dummy-Pad (330, 730) und der Verbindungsstruktur (314, 714),
wobei die Isolationsstruktur (801) in der Halbleiterschicht (326, 726) angeordnet ist.

3. Halbleiterbauelement nach Anspruch 2, wobei eine laterale Abmessung der Isolationsstruktur (801) größer ist als eine laterale Abmessung des Dummy-Pads (330, 730).

4. Halbleiterbauelement nach Anspruch 2 oder 3, das ferner einen ersten Durchkontakt (724) aufweist, der mit der Verbindungsstruktur in Kontakt steht und der vom Dummy-Pad (330, 730) durch die Isolationsstruktur (801) getrennt ist.

5. Halbleiterbauelement nach Anspruch 4, wobei der erste Durchkontakt Wolfram aufweist.

6. Halbleiterbauelement nach Anspruch 1, das ferner aufweist:
einen zweiten Durchkontakt (804), der mit dem Dummy-Pad (330, 730) in Kontakt steht und sich in vertikaler Richtung erstreckt,
wobei die dielektrische Struktur eine dielektrische Schicht (801) zwischen dem zweiten Durchkontakt (804) und der Verbindungsstruktur (314, 714) aufweist.

7. Halbleiterbauelement nach Anspruch 5, wobei der zweite Durchkontakt (804) durch die dielektrische Schicht von der Verbindungsstruktur (314, 714) getrennt ist.

8. Halbleiterbauelement nach einem der Ansprüche 1 bis 7, das ferner eine Bond-Schnittstelle (306, 706) zwischen dem Dummy-Pad (330, 730) und der Bauelementschicht (310, 710) aufweist, wobei die Verbindungsstruktur (314, 714) Bond-Kontakte (318, 320, 718, 720) an der Bond-Schnittstelle (306, 706) aufweist.

9. Halbleitervorrichtung nach Anspruch 8, wobei die Verbindungsstruktur (314, 714) ferner einen Bauelement-Kontakt (316, 716) zwischen der Bond-Schnittstelle (306, 706) und der Bauelementschicht (310, 710) aufweist.

10. Halbleiterbauelement nach einem der Ansprüche 1 bis 9, das ferner aufweist:
ein Pad (346, 746);
einen weiteren zweiten Durchkontakt (344, 744), der mit dem Pad (346, 746) in Kontakt steht;
einen weiteren ersten Durchkontakt (342, 742), der mit dem weiteren zweiten Durchkontakt (344, 744) in Kontakt steht; und
eine weitere Verbindungsstruktur (340, 740), die mit dem weiteren ersten Durchkontakt (342, 742) und der Bauelementschicht (310, 710) in Kontakt steht.

11. Halbleiterbauelement nach Anspruch 10, wobei
das Pad (346, 746) und das Dummy-Pad (330, 730) koplanar sind; und
die Verbindungsstruktur (314, 714) und die weiteren Verbindungsstrukturen (340, 740) koplanar sind.

12. Verfahren zum Herstellen einer Halbleitervorrichtung, aufweisend:
Bilden einer Bauelementschicht (310, 710), die eine Funktionsschaltung (312, 712) aufweist;
Bilden einer Verbindungsstruktur (314, 714) auf der Bauelementschicht (310, 710) und getrennt von der Funktionsschaltung (312, 712);
Bilden eines ersten Durchkontakts (724) auf der Verbindungsstruktur (314, 714), der mit der Verbindungsstruktur (314, 714) verbunden ist;
Bilden einer vergrabenen flachen Grabenisolierung (801) auf der Verbindungsstruktur (314, 714);
Bilden einer Isolationsstruktur (728);
Bilden eines zweiten Durchkontakts (804) durch die Isolationsstruktur (728), der auf der vergrabenen flachen Grabenisolierung (801) landet; und
Bilden eines Dummy-Pads (330, 730) auf und in Kontakt mit dem zweiten Durchkontakt (804); wobei eine dielektrische Struktur zwischen der Bauelementschicht (310, 710) und dem Dummy-Pad (330, 730) die vergrabene flache Grabenisolierung (801) aufweist und wobei die dielektrische Struktur, die Verbindungsstruktur (314, 714) und das Dummy-Pad (330, 730) übereinanderliegen.

13. Verfahren nach Anspruch 12, wobei das Bilden der Isolationsstruktur (728) das Bilden eines Grabens (727) und das Aufbringen eines dielektrischen Materials zum Füllen des Grabens aufweist.

14. Verfahren nach Anspruch 12 oder 13, wobei das Bilden des zweiten Durchkontakts (804) das Bilden eines Lochs (802), das auf die Verbindungsstruktur (314, 714) ausgerichtet ist, und das Aufbringen eines Metalls zum Füllen des Lochs aufweist.

15. Verfahren nach Anspruch 12 bis 14, wobei der zweite Durchkontakt (804) durch die vergrabene flache Grabenisolierung (801) von der Verbindungsstruktur (314, 714) getrennt ist.

## Revendications

1. Dispositif semi-conducteur, comprenant :
une couche de dispositif (310, 710) comprenant un circuit fonctionnel (312, 712) ;
un plot factice (330, 730) ;
une structure diélectrique entre la couche de dispositif et le plot factice (330, 730) et s'étendant dans une direction verticale, la structure diélectrique comprenant une isolation enterrée par tranchée peu profonde (801) ;
une structure d'interconnexion (314, 714) entre la couche de dispositif (310, 710) et la structure diélectrique et s'étendant dans la direction verticale, la structure diélectrique, la structure d'interconnexion (310, 710), et le plot factice (330, 730) étant superposés, la structure d'interconnexion (314, 714) étant déconnectée du circuit fonctionnel (312, 712) ; et
un deuxième contact de via (804) s'étendant verticalement depuis le plot factice (730) à travers une structure d'isolation (728) pour reposer sur l'isolation enterrée par tranchée peu profonde (801).

2. Dispositif semi-conducteur selon la revendication 1, comprenant en outre :
une couche semi-conductrice (326, 726) entre le plot factice (330, 730) et la structure d'interconnexion (314, 714),
dans lequel la structure d'isolation (801) est agencée dans la couche semi-conductrice (326, 726).

3. Dispositif semi-conducteur selon la revendication 2, dans lequel une dimension latérale de la structure d'isolation (801) est supérieure à une dimension latérale du plot factice (330, 730).

4. Dispositif semi-conducteur selon la revendication 2 ou 3, comprenant en outre un premier contact de via (724) en contact avec la structure d'interconnexion et séparé du plot factice (330, 730) par la structure d'isolation (801).

5. Dispositif semi-conducteur selon la revendication 4, dans lequel le premier contact de via comprend du tungstène.

6. Dispositif semi-conducteur selon la revendication 1, comprenant en outre :
un deuxième contact de via (804) en contact avec le plot factice (330, 730) et s'étendant dans la direction verticale,
dans lequel la structure diélectrique comprend une couche diélectrique (801) entre le deuxième contact de via (804) et la structure d'interconnexion (314, 714).

7. Dispositif semi-conducteur selon la revendication 5, dans lequel le deuxième contact de via (804) est séparé de la structure d'interconnexion (314, 714) par la couche diélectrique.

8. Dispositif semi-conducteur selon l'une quelconque des revendications 1 à 7, comprenant en outre une interface de liaison (306, 706) entre le plot factice (330, 730) et la couche de dispositif (310, 710), dans lequel la structure d'interconnexion (314, 714) comprend des contacts de liaison (318, 320, 718, 720) au niveau de l'interface de liaison (306, 706).

9. Dispositif semi-conducteur selon la revendication 8, dans lequel la structure d'interconnexion (314, 714) comprend en outre un contact de dispositif (316, 716) entre l'interface de liaison (306, 706) et la couche de dispositif (310, 710).

10. Dispositif semi-conducteur selon l'une quelconque des revendications 1 à 9, comprenant en outre :
un plot (346, 746) ;
un autre deuxième contact de via (344, 744) en contact avec le plot (346, 746) ;
un autre premier contact de via (342, 742) en contact avec ledit autre deuxième contact de via (344, 744) ; et
une autre structure d'interconnexion (340, 740) en contact avec ledit autre premier contact de via (342, 742) et la couche de dispositif (310, 710).

11. Dispositif semi-conducteur selon la revendication 10, dans lequel
le plot (346, 746) et le plot factice (330, 730) sont coplanaires ; et
la structure d'interconnexion (314, 714) et ladite autre structure d'interconnexion (340, 740) sont coplanaires.

12. Procédé de formation d'un dispositif semi-conducteur, comprenant les étapes consistant à :
former une couche de dispositif (310, 710) comprenant un circuit fonctionnel (312, 712) ;
former une structure d'interconnexion (314, 714) sur la couche de dispositif (310, 710) et déconnectée du circuit fonctionnel (312, 712) ;
former un premier contact de via (724) sur la structure d'interconnexion (314, 714) et connecté à la structure d'interconnexion (314, 714) ;
former une isolation enterrée par tranchée peu profonde (801) sur la structure d'interconnexion (314, 714) ;
former une structure d'isolation (728) ;
former un deuxième contact de via (804) à travers la structure d'isolation (728) pour qu'il repose sur l'isolation enterrée par tranchée peu profonde (801) ; et
former un plot factice (330, 730) sur et en contact avec le deuxième contact de via (804) ; moyennant quoi une structure diélectrique entre la couche de dispositif (310, 710) et le plot factice (330, 730) comprend l'isolation enterrée par tranchée peu profonde (801), et la structure diélectrique, la structure d'interconnexion (314, 714) et le plot factice (330, 730) sont superposés.

13. Procédé selon la revendication 12, dans lequel l'étape consistant à former la structure d'isolation (728) comprend de former une tranchée (727) et de déposer un matériau diélectrique pour remplir la tranchée.

14. Procédé selon la revendication 12 ou 13, dans lequel l'étape consistant à former le deuxième contact de via (804) comprend de former un trou (802) aligné avec la structure d'interconnexion (314, 714) et à déposer un métal pour remplir le trou.

15. Procédé selon la revendication 12 à 14, dans lequel le deuxième contact de via (804) est séparé de la structure d'interconnexion (314, 714) par l'isolation enterrée par tranchée peu profonde (801).
